# FASCICULE DE BREVET EUROPEEN

(11) **EP 3 863 851 B1**
(45) Date de publication et mention de la délivrance du brevet: **26.02.2025**
(21) Numéro de dépôt: 19831789.3
(22) Date de dépôt: 20.11.2019
(51) Int. Cl.: B29B 17/02, B32B 43/00, H01L 31/18

(54) **PROCEDE DE DELAMINATION D'UN DISPOSITIF MULTICOUCHE**
VERFAHREN ZUM DELAMINIEREN EINER MEHRSCHICHTIGEN VORRICHTUNG
METHOD FOR DELAMINATING A MULTILAYER DEVICE

(30) Priorité: 21.11.2018 FR 1871659
(43) Date de publication de la demande: 18.08.2021
(73) Titulaire: Commissariat à l'Energie Atomique et aux Energies Alternatives, 75015 Paris (FR)
(72) Inventeur: RUIZ, Jean-Christophe, 30290 Laudin l'Ardoise (FR); SALES SILVA, Luiz-Paulo, 78300 Poissy (FR); AUDOIN, Claire, 38054 Grenoble Cedex 09 (FR); LUMIA, Guy, 30130 Pont-Saint-Esprit (FR); SERASSET, Marion, 38054 Grenoble Cedex 09 (FR)
(74) Mandataire: Brevalex
(86) Numéro de dépôt international: PCT/FR2019/052764
(87) Numéro de publication internationale: WO 2020/104754

(56) Documents cités:
- EP-A1- 1 619 227
- EP-A1- 1 619 227
- US-A1- 2003 116 176
- US-A1- 2003 116 176
- US-A1- 2004 003 831
- US-A1- 2004 003 831
- US-A1- 2007 264 175
- US-A1- 2007 264 175

## Description

### DOMAINE TECHNIQUE

L'invention concerne un procédé de délamination d'un dispositif multicouche.

Plus exactement, l'invention concerne un procédé de délamination d'un dispositif multicouche comprenant plusieurs couches, au moins l'une de ces couches étant une couche organique, en vue notamment du recyclage des matériaux constituant ces couches.

Le procédé selon l'invention s'applique à la délamination de tout dispositif multicouche, quel qu'il soit.

De tels dispositifs multicouches se rencontrent par exemple dans les emballages alimentaires, les emballages pharmaceutiques, les dispositifs électroniques tels que les écrans d'ordinateurs, les téléphones portables, les téléviseurs, les dispositifs à diodes électroluminescentes notamment à diodes électroluminescentes organiques, etc.

En particulier, le procédé selon l'invention s'applique à la délamination de dispositifs multicouches faisant partie de panneaux photovoltaïques, quelle que soit la technologie envisagée, en vue du recyclage des matériaux les constituant.

### ÉTAT DE LA TECHNIQUE ANTÉRIEURE

Il existe diverses technologies de panneaux photovoltaïques (panneaux PV) cependant les panneaux photovoltaïques qui mettent en œuvre une technologie au silicium - que le silicium soit cristallin, c'est à dire monocristallin ou polycristallin, ou encore amorphe - sont actuellement les plus courants.

Il est à noter que l'on utilise souvent indifféremment les termes panneau photovoltaïque (panneau PV) et module photovoltaïque (module PV).

Cependant, de manière plus précise, on considérera dans la présente, qu'un panneau photovoltaïque (panneau PV) comprend généralement un module photovoltaïque (module PV) ou laminé photovoltaïque (laminé PV), éventuellement un cadre -le plus souvent en aluminium- qui entoure le module PV, et une boîte de jonction.

Il existe des panneaux sans cadre, auquel cas le terme panneau photovoltaïque désigne simplement le module PV ou laminé PV avec la boîte de jonction, et on peut dans ce cas effectivement utiliser indifféremment les termes panneau PV et module PV.

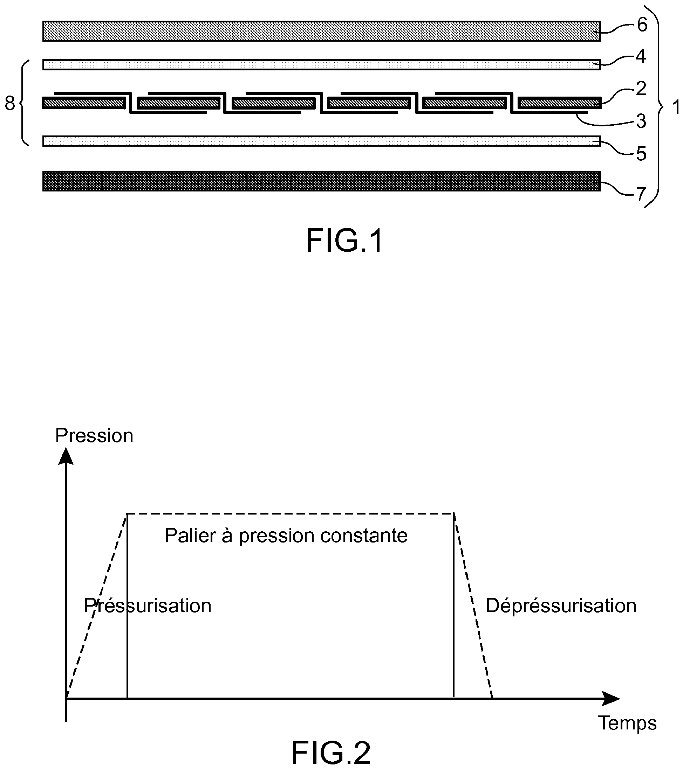

A titre d'exemple, la figure 1 représente la structure d'un panneau photovoltaïque (panneau PV) qui peut également être éventuellement appelé module photovoltaïque (module PV), mettant en œuvre une technologie au silicium, notamment au silicium cristallin.

Le module PV est une structure laminée (1) comprenant différentes couches de matériaux telles que schématisées sur la figure 1. Le module PV (ou laminé PV) comprenant des cellules photovoltaïques ou plaquettes photovoltaïques (2) peut être entouré ou non d'un cadre, notamment en aluminium (non représenté sur la Figure 1) et il est relié à une boîte de jonction (non représentée sur la figure 1).

Les cellules photovoltaïques (cellules PV) (2) sont interconnectées par un ruban conducteur ou bande de connexion métallique (3), généralement en cuivre étamé, et elles sont encapsulées entre deux couches d'encapsulation (4, 5) composées d'une résine polymère organique, qui peut être un copolymère éthylène-acétate de vinyle : EVA.

Cet assemblage de cellules PV interconnectées et encapsulé dans une résine polymère constituant le cœur du module PV (8) est disposé entre une couche de protection supérieure ou face avant (*« front sheet »* en anglais) (6) et une couche de protection inférieure ou face arrière (« *backsheet* » en anglais) (7). La couche de protection supérieure ou face avant (« *front sheet »* en anglais) (6) exposée au rayonnement solaire, peut être constituée par une plaque de verre. La couche de protection inférieure ou face arrière (« *backsheet* » en anglais) (7) peut être constituée par une couche de verre, ou par une film polymère pouvant être un empilement de plusieurs couches de polymère organique, et pouvant contenir au moins une couche de polymère fluoré tel que le polyfluorure de vinyle (PVF) (par exemple le polymère disponible dans le commerce sous le nom de Tedlar^{®}), ou le polyfluorure de vinylidène (PVDF) (par exemple le polymère connu dans le commerce sous le nom de Kynar^{®}).

Par exemple, la face arrière (7) peut être constituée par un empilement comprenant une couche de polyester tel que le polyéthylène téréphtalate (PET) entre deux couches de PVF.

Le recyclage des panneaux PV qui mettent en œuvre une technologie au silicium est réalisé après une première étape de démantèlement qui consiste à séparer la boîte de jonction et le cadre, par exemple en aluminium, si celui-ci est présent, du module photovoltaïque.

Le cadre d'aluminium et la boîte de jonction suivent leur propre filière de traitement des déchets et de recyclage.

Le module PV doit ensuite être traité afin de récupérer les différents composants qui le constituent, à savoir la couche de verre de la face avant et éventuellement de la face arrière, les métaux des bandes de connexion, les cellules PV, les polymères organiques des couches d'encapsulation et de la face arrière.

Le traitement des modules PV peut être réalisé par une ou plusieurs étapes mettant en œuvre des procédés mécaniques, thermiques et/ou chimiques.

Les procédés de traitements mécaniques des modules PV consistent généralement tout d'abord à broyer l'ensemble du module et à séparer sélectivement les différents composants en plusieurs fractions. La composition des différentes fractions dépend de la granulométrie du broyat. Il reste beaucoup d'impuretés dans ces différentes fractions ce qui rend plus difficile la valorisation des matériaux. Ces procédés sont essentiellement utilisés pour la récupération et la valorisation du verre dont la qualité reste cependant inférieure à celle du verre initialement utilisé dans le module. En outre, les métaux à forte valeur ajoutée ne sont en général pas récupérés dans ces procédés.

Il apparaît donc, eu égard aux inconvénients majeurs des procédés impliquant le broyage de la totalité du module, que les différents constituants du module PV (ou laminé PV), à savoir la face avant en verre, la première couche d'encapsulation en polymère EVA (EVA sup), les cellules PV avec les contacts, la seconde couche d'encapsulation en EVA (EVA inf), la face arrière qui peut contenir une couche en polymère fluoré, doivent être séparés, sans réaliser un broyage préalable du module, afin de récupérer séparément des fractions constituées notamment par les cellules PV à base de silicium, par le verre, et par tous les composants valorisables.

La difficulté majeure de cette étape de séparation des différents constituants du module PV est de séparer à la fois du verre et de la face arrière (« *backsheet* »), les cellules de silicium cristallin encapsulées dans l'EVA pour faciliter la valorisation de ces dernières.

En particulier, l'un des principaux obstacles auxquels on se trouve confronté lors de cette étape de séparation est l'élimination du polymère encapsulant (généralement de l'EVA) constituant les couches d'encapsulation, et/ou le décollement de celui-ci aussi bien du verre de la face avant que de la face arrière, que des cellules PhotoVoltaïque (ou cellules PV) afin de réaliser la séparation des divers constituants du module PV.

Pour éliminer le polymère encapsulant, des procédés chimiques ont été étudiés afin de solubiliser ce polymère dans un solvant organique. L'inconvénient majeur est la nécessité d'utiliser des produits chimiques toxiques et le traitement ultérieur de l'effluent liquide.

En outre, l'EVA contenu dans les modules est un polymère réticulé, c'est-à-dire qu'il existe des liaisons covalentes transverses fortes entre les feuillets de polymère qui rigidifient et assurent une cohésion tridimensionnelle de l'ensemble, et qui rendent ce polymère réticulé difficilement soluble dans un solvant organique. Seuls des traitements thermiques, tel qu'un traitement de pyrolyse, permettent de décomposer l'EVA et ainsi de séparer les différents constituants du module PV.

Ces procédés de traitement thermique des modules PV consistent à incinérer, pyrolyser à haute température l'ensemble du module photovoltaïque afin d'éliminer les polymères organiques des couches d'encapsulation et de la face arrière.

L'avantage des procédés de traitement thermique est la rapidité de traitement. De tels procédés, qui sont généralement réalisés à des températures élevées consomment cependant de grandes quantités d'énergie. En effet, notamment, la décomposition de l'EVA utilisé dans les modules, nécessite d'appliquer des températures de traitement pouvant aller jusqu'à 540°C.

Ces procédés de traitement thermique des modules conduisent à l'émission d'effluents toxiques, dangereux, et polluants, ce qui est un inconvénient fondamental de ces procédés de traitement thermique.

En effet, une partie des effluents gazeux produits lors des procédés de traitement thermique, provient de la décomposition des polymères fluorés, tels que le PVF, qui peuvent constituer une des couches de la, face, arrière.

Autrement dit, dans les conditions de température élevée évoquées plus haut qui règnent lors des traitements thermiques, les polymères fluorés, tels que le PVF se décomposent en même temps que l'EVA et forment des fumées, effluents gazeux, nocifs, contenant des composés volatils, polluants, et dangereux.

Un traitement de ces effluents gazeux qui peut s'avérer coûteux doit donc être mis en place.

Le document US-A-6,063,995 [1] concerne un procédé de recyclage de modules photovoltaïques comprenant au moins une couche de matériau polymérique, telle qu'une couche d'EVA, dans lequel on chauffe le module dans une atmosphère inerte à une température suffisante pour décomposer le matériau polymérique, par exemple à une température de 480°C à 540°C. Cependant dans le procédé de ce document, la face de protection arrière doit préalablement être détachée manuellement en la chauffant à une température d'environ 100°C.

On constate donc que les traitements des modules par les procédés mécaniques, thermiques et/ou chimiques exposés plus haut ne sont pas à ce jour satisfaisants ni du point de vue de la qualité des matériaux obtenus notamment du verre, ni du point de vue de l'impact environnemental. En effet, ces traitements génèrent des résidus, liquides ou gazeux, dangereux et toxiques.

C'est la raison pour laquelle il est apparu que le traitement des modules PV en vue de leur recyclage devait impérativement passer par une étape de délamination de ces modules.

Par délamination, on entend la désolidarisation, partielle, et éventuellement totale, d'au moins deux couches adjacentes d'un dispositif ou système multicouche.

Lorsque la désolidarisation desdites au moins deux couches est totale, et se produit sur la totalité de leurs surfaces en contact, on parle alors de séparation.

La désolidarisation partielle, et éventuellement totale, peut ne concerner que deux couches adjacentes du dispositif ou système multicouche, ou plus de deux couches, ou même la totalité des couches du dispositif ou système multicouche.

Cette étape de délamination est très importante et pour des raisons d'efficacité et de rendement matière, il est crucial que le procédé mis en œuvre lors de cette étape permette de récupérer chaque composant constituant les couches du module PV dans son intégralité, afin de favoriser son recyclage et sa valorisation comme source de matière secondaire. Ce procédé doit, en outre, permettre d'obtenir des matériaux de haute pureté tels que le verre.

Ainsi, le document US-A1-2016/0214368 A1 [2] décrit un procédé de séparation de systèmes multicouches, en particulier de modules photovoltaïques, dans lequel les systèmes sont lavés avec un fluide de séparation qui est une dispersion nanométrique, par exemple une microémulsion, comprenant un solvant organique, un composant aqueux et au moins un agent tensioactif.

Le principe de ce procédé est basé sur la réduction des tensions interfaciales entre deux phases (solide/solide et/ou solide/film) afin de permettre leur séparation. L'infiltration du fluide de séparation dans un système multicouche tel que le laminé d'un module PV permet de séparer les différents constituants sans perte de matière et sans dégradation des matériaux valorisables.

Différentes techniques de séparation peuvent ensuite être appliquées afin de récupérer les différentes fractions.

L'avantage majeur de ce procédé est son faible coût énergétique, un rendement élevé, et une bonne qualité des produits de recyclage tel que le verre. Pour améliorer les performances du procédé, le système peut être au préalable concassé en morceaux (pièces de 10 à 30 cm² dans le cas d'un module PV) afin d'augmenter les surfaces d'attaque. La microémulsion peut être également traitée et réutilisée.

Les inconvénients majeurs du procédé de ce document sont les suivants :
- L'obligation de réduire à l'état divisé le panneau avant son traitement.
- Le déplacement des problèmes, car l'efficacité finale du procédé est assujettie aux techniques de séparation mise en œuvre après le traitement décrit.
- La production d'une solution complexe d'effluents comprenant des composés issus de la solubilisation du panneau traité, qui sont mélangés aux solvants et aux différents tensioactifs utilisés. Le volume de cette solution complexe d'effluents est en outre très important.
- Une partie du traitement de la charge à dépolluer et la dépense énergétique qui y est associée sont déplacées vers un post traitement. Il en résulte des impacts sanitaires et environnementaux.
- Le temps de contact important entre les morceaux de modules PV et la microémulsion, qui est dû à une faible efficacité de l'infiltration.

Des procédés de délamination qui mettent en œuvre un fluide à l'état supercritique sont connus (Il s'agit en réalité d'un domaine supercritique, que l'on assimile à un état par souci de clarté et tel qu'il sera présenté dans le reste du texte).

Ainsi, le document WO-A1-2017/037260 [3] décrit un procédé de délamination ou démontage de systèmes multicouches comportant plusieurs couches, dont au moins une couche organique, dans lequel on mélange le système multicouche avec un fluide composé d'au moins un gaz -qui provoque le gonflement d'au moins une des couches- et d'un ou plusieurs liquides non réactifs qui permettent la désolidarisation des couches, ledit fluide étant porté en température et en pression.

La température de traitement peut être supérieure à la température critique du gaz et la pression de traitement peut être supérieure à la pression critique du gaz.

En particulier, la température de traitement peut être comprise entre 30°C et 150°C et la pression de traitement peut être comprise entre 5 et 50 MPa.

Le fluide peut être notamment un mélange de CO₂, d'eau, et d'acétone.

Le système multicouche peut être un module photovoltaïque.

Le procédé de ce document comprend une seule étape de gonflement des couches sous l'action du CO₂ supercritique assisté d'un cosolvant, avec une faible expansion des couches, et par conséquent, une augmentation significative du temps de traitement.

Le graphique de la Figure 2 représente schématiquement la variation de la pression en fonction du temps lors de la mise en œuvre du procédé du document [3].

On constate que dans ce procédé, on augmente tout d'abord la pression depuis une valeur initiale jusqu'à une certaine valeur qui est maintenue constante pendant toute la durée d'un palier de pression, puis on diminue la pression jusqu'à la valeur initiale.

En d'autres termes, le procédé de ce document comprend une seule étape de pressurisation, suivie d'un palier à pression constante, suivi d'une seule étape de dépressurisation. L'étape de pressurisation, et l'étape de dépressurisation ne sont pas répétées.

Les inconvénients majeurs du procédé de ce document sont les suivants:
- L'efficacité du procédé en fonction de la taille des modules traités n'est pas mentionnée. Il n'est pas précisé si l'on traite des panneaux entiers ou prédécoupés.
- Le procédé décrit fait référence à un état supercritique (P > 7,3MPa ; T > 31°C concernant le CO₂) comme le seul état recherché (même si les plages débutent à 5MPa et 30°C) sans qu'il soit explicitement démontré que cet état supercritique soit à l'origine du gonflement constaté.
- La délamination induite par un gonflement des polymères lui-même induit par la dépressurisation n'est pas le phénomène recherché, mais la conséquence d'un changement d'état du fluide au moment de la remise à la pression atmosphérique pour récupérer l'objet traité dans l'autoclave.
- L'étape de pressurisation et l'étape de dépressurisation ne sont pas contrôlées Les durées de montée et de descente en pression ne sont pas précisées.
- Le CO₂ est additionné de cosolvants comme de l'eau ou de l'acétone qui rendent le procédé moins élégant, car il génère très certainement un volume significatif d'effluents dont la composition n'est pas décrite. Comme pour le document US- A1-2016/0214368 A1 [2], une partie du problème est déplacée vers l'effluent qui doit être traité par des procédés complémentaires.
- Le recours à des cosolvants montre que, dans les conditions de ce procédé, le CO₂ seul ne permet pas une délamination complète du panneau PV.

Le document WO-A1-2017/009062 [4] propose un procédé de recyclage des modules PV, dans lequel les modules sont soumis à un traitement hydrothermal oxydant sous une atmosphère subcritique.

Le traitement hydrothermal oxydant peut être réalisé en présence de peroxyde d'hydrogène ou d'acide nitrique, auquel cas le traitement hydrothermal oxydant est réalisé à une température comprise entre 130°C et 150°C et à une pression comprise entre 0,5 et 2,5 MPa.

Ou bien, le traitement hydrothermal oxydant peut être réalisé en présence d'un gaz oxydant tel que l'oxygène, auquel cas le traitement hydrothermal oxydant est réalisé à une température comprise entre 150°C et 250°C et à une pression comprise entre 0,5 et 2,5 MPa.

Les inconvénients majeurs du procédé de ce document [4] sont les suivants :
- Ce procédé, dans lequel, le fluide subcritique est l'eau, nécessite des durées de traitement longues, comprises entre 3 et 6 heures, qui sont dues probablement à la limitation diffusive du milieu dans les couches.
- Ce procédé ne décrit pas précisément la qualité et/ou l'altération des matériaux à valoriser/recycler.

Le document EP-A1-1 619 227 décrit un procédé de séparation d'un support adhérent (« *adherend* ») collé en utilisant un adhésif, un procédé pour récupérer une pièce électronique à partir d'un stratifié comprenant ladite pièce, collé par un adhésif ou encore un procédé de séparation d'un verre stratifié obtenu en prenant en sandwich un adhésif ou un film intercalaire en une résine thermoplastique entre des plaques de verre. Le procédé décrit dans le document EP-A1-1 619 227 comprend une mise en contact avec un fluide qui est un gaz à la température normale et à la pression normale dans un réacteur résistant à la pression ; l'établissement d'une haute pression à l'intérieur du réacteur, et le relâchement de la pression à l'intérieur du réacteur résistant à la pression. Toutefois, peu d'indication est fournie sur la durée de l'étape d'établissement de la haute pression et celle de l'étape de compression et il n'est pas envisagé que ces deux étapes soient répétées.

Il existe donc, au regard de ce qui précède, un besoin pour un procédé de délamination d'un dispositif multicouche tel qu'un module photovoltaïque, comprenant plusieurs couches, au moins l'une de ces couches étant une couche organique, qui permette de délaminer les différentes couches d'un tel dispositif multicouche en vue de leur récupération, recyclage, en un nombre limité d'étapes et en une durée réduite.

Il existe en particulier un besoin pour un tel procédé, qui permette de dégrader, voire d'éliminer la ou les couches organiques et qui permette de récupérer les composants valorisables tels que les métaux, le verre, les cellules PV, d'un tel dispositif.

Il existe notamment un besoin pour un tel procédé qui permette de récupérer des composants valorisables tel que le verre d'une qualité élevée, non dégradés, permettant ainsi leur recyclage pour la fabrication de nouveaux dispositifs multicouche analogues.

Il existe aussi un besoin pour un tel procédé qui soit respectueux de l'environnement, qui n'utilise pas de solvants organiques toxiques et ne produise pas de déchets toxiques nécessitant un traitement long et coûteux.

Le but de la présente invention est de répondre entre autres à ces besoins.

Le but de la présente invention est encore, de fournir un tel procédé de délamination qui ne présente pas les inconvénients, défauts, limitations et désavantages des procédés de l'art antérieur, et qui résolve les problèmes des procédés de l'art antérieur.

### EXPOSÉ DE L'INVENTION

Ce but, et d'autres encore, sont atteints, conformément à l'invention, par un procédé de délamination d'un dispositif multicouche comprenant plusieurs couches, au moins l'une de ces couches étant une couche organique, ledit procédé comprenant au moins les étapes successives suivantes :
a) on met en contact le dispositif multicouche avec un fluide ;
b) on effectue une compression brutale et instantanée du fluide en augmentant de manière brutale et instantanée la pression du fluide jusqu'à une pression P1, à laquelle le fluide se trouve dans un premier état physique;
c) on effectue une décompression brutale et instantanée du fluide en diminuant de manière brutale et instantanée la pression du fluide depuis la pression P1 jusqu'à une pression P2 à laquelle le fluide se trouve dans un deuxième état physique, la pression P2 étant inférieure à la pression P1;
d) on répète la succession de l'étape b) et de l'étape c), la succession des étapes b) et c) constituant une pulsation ou cycle;
e) on récupère le dispositif multicouche délaminé,
la compression brutale et instantanée du fluide et la décompression brutale et instantanée du fluide ayant chacune une durée de 1 seconde à 30 secondes.

Par couche organique, on entend généralement une couche comprenant, de préférence constituée par, un ou plusieurs polymères organiques.

Avantageusement, lors de l'étape a), on met en contact le dispositif multicouche avec un fluide à une température T0, telle que la température ambiante, et une pression P0, telle que la pression atmosphérique.

Avantageusement après l'étape a), et avant l'étape b), on réalise les étapes successives a1) et a2) suivantes :
a1) on amène la température du fluide à une température T1, et la pression du fluide à la pression P1, dans lesquelles (c'est-à-dire température T1 et pression P1) le fluide se trouve dans un premier état physique, et on observe un palier à ladite pression P1 pendant une durée t1;
a2) on effectue une décompression brutale et instantanée du fluide en diminuant de manière brutale et instantanée la pression du fluide depuis la pression P1 jusqu'à la pression P2, et on observe un palier à ladite pression P2 pendant une durée t2;

à l'issue de l'étape b), on effectue l'étape b1), suivante :
   b1) on observe un palier à la pression P1 pendant une durée t1;
à l'issue de l'étape c), on effectue l'étape c1) suivante :
   c1) on observe un palier à la pression P2 pendant une durée t2; puis
   d1) on répète la succession des étapes b) à c1), cette succession des étapes b) à c1) constituant une pulsation ou cycle; puis
à l'issue de l'étape d1), et avant l'étape e), on effectue les étapes successives d2) et d3) suivantes :
   d2) on effectue une compression brutale et instantanée du fluide en augmentant de manière brutale et instantanée la pression du fluide depuis la pression P2, jusqu'à la pression P1, et on observe un palier à ladite pression P1 pendant une durée t1;
   d3) on effectue une décompression brutale et instantanée du fluide, en diminuant la pression du fluide depuis la pression P1, de préférence jusqu'à la pression P0, telle que la pression atmosphérique.

Avantageusement, lors de l'étape a1), on amène le fluide à la température T1, et la pression du fluide à la température P1, de manière brutale et instantanée.

En effet, il est recommandé d'opérer une élévation de la pression la plus rapide possible proche de l'instantané. En fait la 1^{ère} montée au palier haute pression peut s'effectuer de manière non instantanée, mais lors de la mise en régime du système pulsé, il est recommandé d'effectuer des montées et descentes haute pression/basse pression selon une dynamique la plus rapide possible, afin de produire des pulses carrées et dont la forme se rapproche d'un parallélogramme rectangle. En fait l'expansion de matériaux organiques, tels que de polymères, utile à la délamination s'effectue essentiellement lors de la détente, qui, par sa brutalité, va induire des contraintes mécaniques très fortes en fonction de l'instantanéité. Il est néanmoins probable qu'une montée en pression brutale est de nature à favoriser la pénétration du fluide dans le matériau à traiter.

Avantageusement, la pression P2 peut être égale à la pression P0, de préférence P0 peut être la pression atmosphérique (c'est-à-dire en fait l'absence de pression).

La pression P2 est choisie en fonction des besoins, et de la nature des matériaux organiques tels que des polymères de ladite au moins une couche organique.

Le procédé selon l'invention comprenant les étapes a) à e) peut être dénommé traitement au fluide pulsé ou par un fluide pulsé.

La compression brutale et instantanée du fluide et la décompression brutale et instantanée du fluide ont chacune une durée de 1 seconde à 30 secondes, notamment de 1 seconde à 10 secondes, en particulier de 1 seconde à 2 ou 5 secondes.

En d'autres termes, notamment lors des étapes b), et c), on augmente ou on diminue de manière brutale et instantanée la pression du fluide en une durée de 1 seconde à 30 secondes, notamment de 1 seconde à 10 secondes, en particulier de 1 seconde à 2 ou 5 secondes.

Le procédé selon l'invention comprend une suite spécifique d'étapes spécifiques qui n'a jamais été décrite ou suggérée dans l'art antérieur, tel que représenté notamment par les documents cités plus haut. En particulier, la succession d'une compression brutale et instantanée du fluide et d'une décompression brutale et instantanée du fluide entre des états physiques différents, cette succession étant répétée n'a jamais été décrite ou suggérée dans l'art antérieur.

On peut dire que le procédé selon l'invention consiste à réaliser des cycles répétés de compression, pressurisation et de dépressurisation, décompression.

Généralement, le procédé réalise une pressurisation initiale jusqu'à une pression P1, que l'on peut qualifier de haute pression, à laquelle le fluide, tel que le CO₂, se trouve dans un premier état physique, par exemple un état supercritique.

Un palier à cette pression P1, qui est maintenue stable, peut généralement être observé pour garantir une bonne interaction du fluide tel que le CO₂ SC avec le dispositif multicouche, tel qu'un module PV, et assurer notamment la pénétration du fluide dans ce dispositif, en particulier dans les couches organiques polymériques.

Ensuite, le procédé réalise une dépressurisation brutale jusqu'à une pression P2, que l'on peut qualifier de basse pression, à laquelle le fluide, tel que le CO₂, se trouve dans un deuxième état physique, par exemple un état gazeux.

Un palier à cette pression P2, qui est maintenue stable, peut généralement être observé.

Contrairement aux procédés de l'art antérieur, dans lesquels le fluide reste dans un même état physique lors de sa mise en contact avec le dispositif multicouche, on effectue dans le procédé selon l'invention, lors d'une pulsation, un premier changement d'état par exemple depuis un état gazeux jusqu'à un état supercritique puis un deuxième changement d'état par exemple depuis un état supercritique jusqu'à un état gazeux, et éventuellement jusqu'à l'état liquide ou solide selon les températures et les différences de pression appliquées.

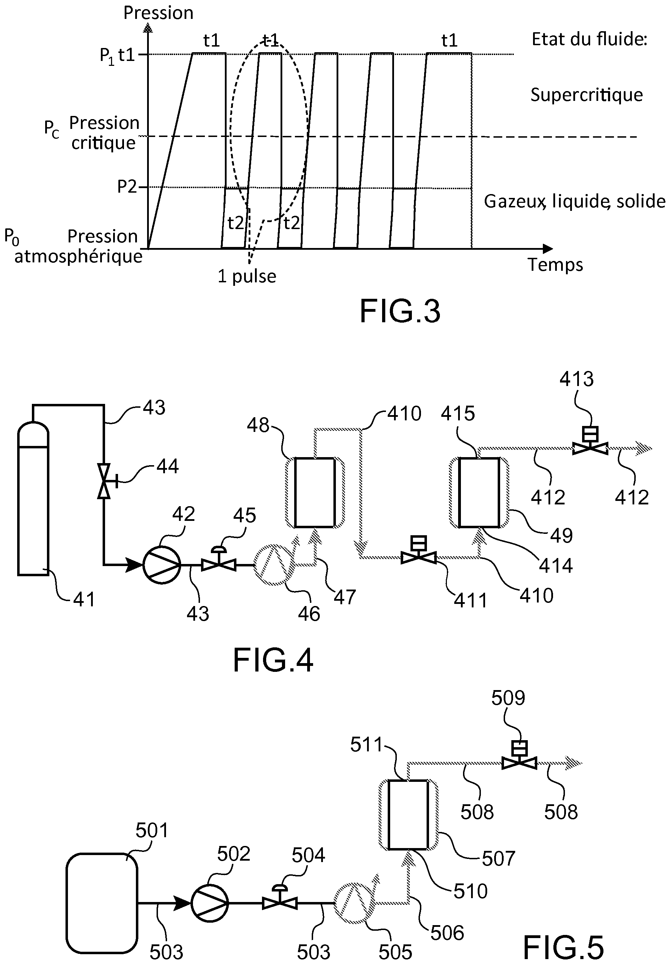

Cette mise en œuvre de la pulsation et du traitement, que l'on appellera traitement au fluide pulsé, par exemple au CO₂ pulsé est illustrée dans la Figure 3 décrite en détail plus bas.

Au cours d'une pulsation du procédé selon l'invention, il se produit successivement, lors de la compression très rapide, instantanée, une insertion par diffusion du fluide, tel que le CO₂, dans le premier état physique, par exemple supercritique, au cœur de la matrice des couches organiques du dispositif multicouche traité, puis, par décompression très rapide, instantanée, une évacuation brutale du fluide, tel que le CO₂, dans le deuxième état physique, par exemple gazeux, de la matrice.

Chaque cycle de compression/décompression s'accompagne d'une augmentation/diminution du volume molaire du fluide, tel que le CO₂. Ainsi lors d'un cycle, il se produit tout d'abord, lors de la compression, une imprégnation des matériaux qui sont saturés de molécules de fluide tel que le CO₂. Cette imprégnation est suivie d'un dégonflement, qui induit des déformations des matériaux traités, dues à l'évacuation volontairement brutale des molécules de fluide, tel que le CO₂, lors de la décompression.

En effet, l'incorporation ou la diffusion forcée et très rapide du fluide, tel que le CO₂, dans la matrice des couches organiques, par exemple dans la matrice des polymères, suivie d'un retrait tout aussi rapide du CO₂ des couches organiques, exacerbe les tensions mécaniques entre les parties souples et les parties rigides du dispositif multicouche, par exemple entre la structure rigide et la structure souple du module PV. Ces tensions mécaniques sont dues à la brutalité des variations de pression appliquées au dispositif multicouche.

Autrement dit, à la pressurisation, on a une imprégnation forcée des matériaux organiques, tels que des polymères, par le fluide, tel que le CO₂. A la dépressurisation, du fait de la brutalité de celle-ci, et du fait du retrait violent du fluide, tel que CO₂, les matériaux organiques se mettent à s'expanser, gonfler grâce à une augmentation de leurs volumes par moussage. Une fois à la pression atmosphérique, tout le fluide, tel que le CO₂ n'est pas évacué, et il continue donc à sortir. À chaque fois qu'un mouvement de fluide, tel que le CO₂ entrant ou sortant s'effectue, il provoque une rétractation des couches de matériaux organiques, tels que des polymères ce qui induit un décollement des couches de matériaux organiques, qui sont poreuses, par rapport aux couches de matériaux denses comme le verre, et à la couche de cellules PV à base de silicium.

Si lors d'une pulsation, la décompression est poursuivie jusqu'à la pression atmosphérique, il peut se produire un abaissement très important de la température (liée à l'enthalpie du fluide notamment dans le cas du CO₂) jusqu'à des valeurs négatives, qui peuvent même aller jusqu'à une température inférieure à -50°C. Le fluide, tel que le CO₂, initialement, par exemple à l'état supercritique passe alors successivement à l'état gazeux, liquide et jusqu'à l'état solide. Cet abaissement de la température ajoute une contrainte mécanique supplémentaire à celle déjà induite par la décompression, en particulier sur les couches organiques polymériques, ce qui facilite la délamination.

On peut estimer que, dans ce cas, les couches organiques, notamment en polymères organiques, subissent un traitement par le froid ou « Cryo-traitement » très brutal et susceptible de les désolidariser des autres couches, par exemple de la couche vitreuse.

Après la première pulsation, afin d'accentuer cet effet mécanique de gonflement des matériaux organiques, notamment des polymères organiques, tels que l'EVA, le système est pressurisé à nouveau jusqu'à la pression P1 (haute pression) dans lequel le fluide est par exemple à l'état supercritique, puis dépressurisé de nouveau jusqu'à la pression P2. Puis de nouveaux cycles sont réalisés en nombre autant que nécessaire pour permettre l'expansion du ou des polymères organiques (par un phénomène d'expansion, moussage, « *foaming* »).

Selon l'invention, les pulsations sont réalisées de manière brutale et instantanée aussi bien pour la pressurisation, compression que pour la dépressurisation, décompression, tel que cela est schématisé sur la Figure 3.

Le procédé selon l'invention répond aux besoins énumérés plus haut et apporte une solution aux problèmes des procédés de l'art antérieur.

Le procédé selon l'invention permet de s'affranchir de l'utilisation de cosolvants tels que l'acétone qui sont utilisés notamment dans le procédé du document [3] déjà cité. Dans le procédé selon l'invention, les imprégnations et « dégonflements » successifs des couches organiques vont induire une déformation mécanique des matériaux organiques, tels que des polymères organiques, plus poussée qu'un simple trempage unique dans un fluide supercritique tel que le CO₂ ou le CO₂ additionné d'un cosolvant.

En outre, le procédé selon l'invention a une durée plus courte que les procédés de l'art antérieur, et son bilan économique est bien plus favorable.

La répétition de la pulsation haute pression /basse pression permet d'améliorer la diffusion du fluide pour des surfaces qui peuvent aller de quelques cm² jusqu'à plusieurs m². Des dispositifs multicouches tels que des modules photovoltaïques entiers, avec une surface importante peuvent donc être traités par le procédé selon l'invention.

Avantageusement, le premier état physique peut être un état supercritique, et le deuxième état physique peut être un état gazeux, liquide ou solide; ou bien le premier état physique peut être un état gazeux et le deuxième état physique peut être un état liquide ou solide ; ou bien le premier état physique peut être un état liquide et le deuxième état physique peut être un état solide.

C'est dans la zone de pression délimitée par les valeurs de pressions P1 et P2 que les changements d'état se déroulent, par exemple depuis l'état supercritique vers l'état gazeux ou liquide ou solide, et inversement depuis l'état gazeux ou liquide ou solide vers l'état supercritique.

Ce changement d'état peut être aussi un changement d'état depuis l'état gazeux vers l'état liquide ou solide et inversement, ou de l'état liquide vers l'état solide et inversement.

De préférence, le premier état physique est supercritique et le deuxième état physique est un état gazeux.

En effet, l'état supercritique d'un fluide, tel que le CO₂, que l'on peut dénommer CO₂ SC (rappelons que l'on utilise les termes d'état supercritique, mais qu'il s'agit plutôt d'un domaine supercritique, que l'on assimile à un état par souci de clarté) est connu pour présenter les avantages d'un milieu intermédiaire entre les phases liquide et gazeuse.

Il présente une masse volumique équivalente à celle d'un liquide ce qui lui confère un incroyable pouvoir solvant apolaire. En même temps, le fluide supercritique, tel que le CO₂ SC a une faible viscosité et une grande diffusivité (similaire à l'état gazeux) lui conférant ainsi une considérable capacité de pénétration dans les milieux poreux.

Dans le cadre du traitement des dispositifs multicouches, tels que les modules PV, ces caractéristiques des fluides supercritiques, tels que le CO₂ SC, leurs confèrent, la capacité de diffuser au cœur même des matériaux poreux (diffusion à l'échelle moléculaire) par imprégnation des couches organiques lors des phases de compression, et de s'évacuer aussi rapidement et de manière brutale des couches organiques lors de la décompression.

Cette alternance d'imprégnation/dégonflement des couches organiques, notamment, polymériques du dispositif multicouche, tel qu'un module PV permet en fonction du nombre de cycles et de la différence de pression appliqués, de délaminer les couches organiques, notamment polymériques, et permet la récupération de ces couches organiques, au même titre que les autres composants ou composés valorisables, le verre, les métaux, la cellule PV.

Avantageusement, la pression P1 peut être de 5 à 70 MPa, et la pression P2 peut être de 0,1 à 60 MPa.

La différence de pression entre la pression haute P1 et la pression basse P2 est donc, avantageusement, de 4,9 à 69,9 MPa.

Avantageusement, la succession de l'étape de compression b) et de l'étape de décompression c) est réalisée de 2 à 1000 fois, de préférence de 2 à 500 fois, de préférence encore de 2 à 100 fois, mieux de 2 à 50 fois, notamment de 2 à 10 fois, par exemple de 2 à 3, 4, 5 ou 6 fois.

Autrement dit, la pulsation ou cycle est réalisé de 2 à 1000 fois, de préférence de 2 à 500 fois, de préférence encore de 2 à 100 fois, mieux de 2 à 50 fois, notamment de 2 à 10 fois, par exemple de 2 à 3, 4, 5 ou 6 fois.

Avantageusement, le fluide peut être choisi parmi le dioxyde de carbone CO₂; l'hexafluorure de soufre ; le protoxyde d'azote ; les alcanes linéaires ou ramifiés, de préférence les alcanes linéaires ou ramifiés de 1 à 10 atomes de carbone, notamment de 1 à 5 atomes de carbone, tels que le méthane, les propanes, les butanes, et les pentanes ; les alcanes cycliques, de préférence les alcanes cycliques de 3 à 10 atomes de carbone ; les alcènes linéaires ou ramifiés, de préférence les alcènes linéaires ou ramifiés de 2 à 10 atomes de carbone, notamment de 2 à 5 atomes de carbone, tels que l'éthylène et le propylène ; les alcools, de préférence les alcools aliphatiques de 1 à 5 atomes de carbone comme le méthanol, l'éthanol, les propanols, et les butanols ; et leurs mélanges ; notamment, le fluide peut être choisi parmi les mélanges de dioxyde de carbone CO₂ et d'au moins un autre fluide choisi parmi les fluides énumérés précédemment.

Avantageusement, la durée t1 peut être de 5 secondes à 30 minutes, notamment de 5 secondes à 5, 10, ou 15 minutes, et la durée t2 peut être de 5 secondes à 30 minutes, notamment de 5 secondes à 5, 10, ou 15 minutes.

En effet, les durées des paliers peuvent être ajustées en fonction de la nature des polymères à traiter.

La durée t1 peut être inférieure à la durée t2 ou bien la durée t1 peut être supérieure à la durée t2 ; en particulier, la durée t1 peut (comparativement à la durée t2) être une durée courte, par exemple de 5 secondes à 5 minutes, et la durée t2 peut être une durée longue, par exemple de 5 minutes à 30 minutes ; ou bien la durée t1 peut (comparativement à la durée t2) être une durée longue, par exemple de 5 minutes à 30 minutes, et la durée t2 peut être une durée courte, par exemple de 5 secondes à 5 minutes.

Autrement dit, les paliers peuvent comprendre des paliers haute pression courts, suivis de paliers basse pression (ces basses pressions pouvant même aller jusqu'à la pression atmosphérique) longs ou inversement.

Le fluide préféré est le dioxyde de carbone CO₂.

En effet, le dioxyde de carbone présente notamment l'avantage d'une mise en œuvre relativement facile, car il est bon marché, non toxique, ininflammable et possède des conditions critiques facilement accessibles (pression critique : Pc de 7,3 MPa et température critique Tc de 31,1°C).

Avantageusement, un cosolvant peut être ajouté au fluide.

Avantageusement, le cosolvant peut être choisi parmi les gaz dont la pression et la température du point critique sont inférieures ou égales à celles du CO₂, comme le N₂O, le propane ou le butane ; et leurs mélanges.

Autrement dit, le cosolvant peut être choisi parmi les gaz comme le N₂O, le propane ou le butane et tous les autres gaz dont les coordonnées (pression et température) du point critique sont inférieures ou égales à celles du CO₂, et leurs mélanges.

Ou, le cosolvant peut être choisi parmi l'eau ; les solutions aqueuses ; les alcools, de préférence les alcools aliphatiques de 1 à 5 atomes de carbone comme le méthanol, l'éthanol, les propanols, et les butanols ; les cétones, de préférence les cétones linéaires ou ramifiées de 3 à 10 atomes de carbone comme l'acétone ou la méthyl-éthyl-cétone, ou les cétones cycliques ; les terpènes ; les hydrofluoroéthers ; les cyclohexanes ; et leurs mélanges.

Avantageusement, lesdites solutions aqueuses peuvent être choisies parmi les solutions de détergents comme les tensioactifs anioniques et/ou cationiques; les solutions d'agents complexants ou d'agents chélatants ; et leurs mélanges.

Avantageusement, le cosolvant peut être ajouté au fluide à raison de 0,01 à 30% en masse, de préférence à raison de 0,01 à 10% en masse.

Dans le procédé selon l'invention, le cosolvant ajouté au fluide, du fait des pulsations mises en œuvre, peut subir des changements d'état successifs.

En effet, par exemple, un cosolvant pourra être soluble dans le fluide, tel que le CO₂, à l'état supercritique, à haute pression, permettant ainsi son transport au cœur des couches en polymères organiques. Et ce même solvant se condensera, en particulier à l'état liquide, dans le fluide, tel que le CO₂ à l'état gazeux, à basse pression. Le cosolvant aura alors un effet solvant classique sur les polymères. L'addition d'un cosolvant n'est pas recherchée dans le procédé selon l'invention mais peut éventuellement s'avérer nécessaire pour le traitement de certains matériaux polymères difficiles à déformer, notamment de polymères peu poreux à la diffusion.

Avantageusement, préalablement à l'étape a) on découpe le dispositif multicouche en morceaux de plus petite taille (que la taille du dispositif multicouche entier).

Toutefois, le procédé selon l'invention permet de traiter des dispositifs multicouches entiers même de grandes tailles sans qu'il soit nécessaire de procéder à une découpe préalable.

Avantageusement, à l'issue de l'étape e) on peut réaliser un ou plusieurs post-traitements choisis parmi les traitements chimiques, mécaniques, et les opérations de démontage, y compris les opérations de démontage manuelles.

Le procédé des étapes a) à e) peut être qualifié de traitement au fluide pulsé, par exemple au CO₂ supercritique pulsé. Lorsque ce traitement au fluide pulsé est associé à un post-traitement tel qu'un post-traitement à la vapeur saturée, à l'eau subcritique ou à l'eau supercritique, il peut être considéré comme un prétraitement, c'est-à-dire un procédé permettant de préparer le dispositif multicouche tel qu'un module PV audit post-traitement tel qu'un traitement à la vapeur saturée, à l'eau subcritique ou à l'eau supercritique. En effet, le traitement au fluide pulsé favorise les post-traitements en augmentant les surfaces de contact interfaciales et facilite ainsi le démantèlement par une action ciblée sur les couches organiques polymériques, ce qui permet la séparation des couches valorisables comme les couches de verre et les cellules PV.

A l'issue de l'étape e) on peut, selon un premier mode de réalisation, réaliser l'étape f) suivante :
f) on met en contact le dispositif multicouche avec une phase constituée par de la vapeur d'eau saturée, et éventuellement par un agent oxydant tel que l'oxygène pur, l'air, ou le peroxyde d'hydrogène.

De préférence, on peut mettre en contact le dispositif multicouche avec une phase constituée par de la vapeur d'eau saturée et éventuellement par un agent oxydant tel que l'oxygène pur, l'air, ou le peroxyde d'hydrogène , à une pression de 0,2 à 20 MPa et à une température de 120°C à 300°C ; de préférence pendant une durée de 15 à 180 minutes, de préférence encore de 15 à 60 minutes, mieux de 45 à 60 minutes.

Ce traitement avec de la vapeur d'eau saturée peut être qualifié de post-traitement.

L'eau lorsqu'elle elle se trouve à l'état de vapeur saturée permet une délamination interfaciale des couches par effet solvant sur les composés polaires, mais également en raison de son potentiel énergétique.

La vapeur d'eau saturée à l'équilibre thermodynamique présente une valeur d'enthalpie plus élevée que la phase liquide.

A titre d'exemple, dans un équilibre thermodynamique liquide-vapeur d'un système ne contenant que l'eau à 250 °C et 4,0 MPa, l'enthalpie de la phase liquide est d'environ 19,6 kJ/mol et l'enthalpie de la phase vapeur est d'environ 50,5 kJ/mol [5].

Le couplage du traitement du dispositif multicouche par une succession d'étapes de compressions et de décompressions brutales et instantanées du fluide, tel que le CO₂ (traitement dit traitement au fluide pulsé, par exemple traitement au CO₂ pulsé), qui permet un gonflement des couches organiques, par exemple des couches de polymères organiques, du dispositif multicouche (ce dispositif multicouche étant un « millefeuille » de couches organiques et inorganiques) tel qu'un module PV, avec un traitement par la vapeur d'eau saturée permet, en raison d'une meilleure diffusion de l'eau à l'état gazeux et de sa grande énergie, de délaminer efficacement les différentes couches qui constituent le dispositif multicouche.

### Ce couplage permet d'accroître le phénomène de délamination

Le fait d'ajouter une étape supplémentaire avec de l'eau chauffée sous pression induit des conditions plus drastiques, qui conduisent à une dégradation plus complète des couches polymères organiques offrant ainsi la possibilité de récupérer chacune des couches séparément , à savoir : le verre, une partie de la couche de silicium.

Le procédé selon l'invention permet donc ici une approche graduée de la délamination.

En effet si l'on estime que la délamination obtenue à l'issue du seul traitement par le fluide pulsé n'est pas suffisante, et si l'on souhaite une délamination plus importante voire totale alors la mise en œuvre du post-traitement par la vapeur d'eau saturée permet d'obtenir la délamination voulue.

A l'issue de l'étape e) on peut, selon un deuxième mode de réalisation, réaliser l'étape g) suivante :
g) on met en contact le dispositif multicouche avec une phase constituée par de l'eau subcritique, et éventuellement par un agent oxydant tel que l'oxygène pur, l'air ou le peroxyde d'hydrogène.

De préférence, on peut mettre en contact le dispositif multicouche avec une phase constituée par de l'eau subcritique et éventuellement par un agent oxydant tel que l'oxygène pur, l'air ou le peroxyde d'hydrogène, à une pression inférieure à 22,1 MPa, de préférence de 0,2 à 20 MPa, et à une température inférieure à 374°C, de préférence entre la température d'ébullition de l'eau et 374°C, de préférence encore de 150°C à 370°C, mieux de 150°C à 350°C, mieux encore de 150°C à 200°C (par exemple de 350°C ou 370°C) ; de préférence pendant une durée de 30 à 180 minutes, de préférence encore de 30 à 60 minutes, mieux de 45 à 60 minutes.

Il est à noter que les température et pression critiques de l'eau se situent à 374°C et 221 bars (22,1 MPa). On parle d'eau subcritique (terme bien connu) dans un domaine où l'eau surchauffée se trouve proche du point critique avec une densité qui diminue à pression constante inférieure à 221 bars (22,1 MPa).

Là-encore, ce traitement avec de l'eau subcritique peut être qualifié de post-traitement.

Ce post traitement, qui est consécutif au traitement par une succession d'étapes de compression et de décompressions brutale et instantanée du fluide (CO₂ pulsé), est réalisé dans les conditions subcritiques en présence d'une phase aqueuse à une température et à une pression inférieures aux températures et pressions critiques de l'eau, à savoir, à une température T < 374 °C et à une pression P < 22,1 MPa.

Dans les conditions de température et de pression mentionnées plus haut, l'eau est sous pression, se trouve à une température inférieure à sa température critique (< 374°C), et présente l'avantage d'être non seulement un bon solvant mais également un milieu réactif capable d'hydrolyser et donc de dégrader de manière plus efficace encore les couches organiques.

Ce post-traitement à l'eau subcritique permet de graduer, moduler à volonté le traitement du dispositif multicouche selon l'objectif visé qui peut aller d'une délamination partielle ou complète des couches organiques, notamment des couches organiques polymériques, si l'on met en œuvre seulement le traitement au CO₂ pulsé, jusqu'à une décomposition partielle ou quasi totale des couches organiques polymériques.

Ce post-traitement peut ainsi être mis en œuvre avec deux objectifs différents en fonction de la température et de la durée du post-traitement.

Ce post-traitement peut être un traitement intervenant en complément du traitement par fluide pulsé pour parfaire la délamination des couches, en fonction du degré de délamination déjà obtenu par le traitement par fluide pulsé.

On mettra alors en œuvre des températures, généralement de 150 à 200°C et des durées de traitement courtes, généralement de 30 à 60 minutes.

Ou bien, ce post traitement peut être un traitement ayant pour but la dégradation des couches polymériques en complément de la délamination déjà obtenue par le traitement par fluide pulsé.

On mettra alors en œuvre des températures élevées, généralement de 200 à 370°C, et des durées de traitement longues, généralement de 60 à 180 minutes.

Le post-traitement par l'eau subcritique peut être réalisé en présence ou non d'un oxydant tel que de l'oxygène, de l'air, ou du peroxyde d'hydrogène H₂O₂.

La présence mais non obligatoire d'un oxydant dans ces conditions permet de réduire de manière significative les durées de traitement et de permettre d'affiner encore plus la gradation du procédé décrit par la présente invention.

A l'issue de l'étape e), on peut, selon un troisième mode de réalisation, réaliser l'étape h) suivante :
h) on met en contact le dispositif multicouche avec une phase constituée par de l'eau supercritique, et éventuellement par un agent oxydant tel que l'oxygène pur, l'air ou le peroxyde d'hydrogène.

De préférence, on peut mettre en contact le dispositif multicouche avec une phase constituée par de l'eau supercritique et éventuellement par un agent oxydant tel que l'oxygène pur, l'air ou le peroxyde d'hydrogène à une pression supérieure à 22,1 MPa, de préférence à une pression de 22,1 MPa à 40 MPa ; et à une température supérieure à 374°C, de préférence de 400 à 500°C ; de préférence pendant une durée de 10 à 180 minutes, de préférence encore de 20 à 120 minutes.

Ici aussi, ce traitement avec de l'eau supercritique peut être qualifié de post-traitement.

L'eau à l'état supercritique (Pc > 22,1 MPa et Tc > 374°C) possède des caractéristiques très particulières. En raison d'une baisse considérable de la constante diélectrique dans ce domaine (qui est de 80 dans les conditions normales de pression et de température, et qui est de moins de 10 au-dessus du point critique) l'eau dite supercritique présente des propriétés de solvatation proches de celle d'un solvant organique.

En contrepartie, les sels minéraux présentent une solubilité très basse dans l'eau supercritique. Les composés organiques solubilisés en toute proportion dans l'eau supercritique sont hydrolysés puis décomposés rapidement.

Les réactions d'hydrolyse pouvant être quasiment athermiques, il est alors nécessaire d'apporter de l'énergie qu'il est possible de limiter avec un apport d'un agent oxydant dans le procédé dans des conditions sous-stœchiométriques.

La réaction d'oxydation hydrothermale étant, quant à elle exothermique, de l'énergie supplémentaire est alors disponible pour décomposer, avec une cinétique rapide, tout composé organique présent dans le milieu.

Le couplage du traitement par un fluide pulsé, tel que le CO₂ pulsé, avec le post-traitement par de l'eau supercritique avec ou sans agent oxydant tel que l'oxygène pur, l'air ou le peroxyde d'hydrogène permet de manière très efficace et, dans un temps très court, de décomposer les composés organiques constitutifs du dispositif multicouche tel qu'un module PV et de récupérer les composants inorganiques du dispositif multicouche, tels que le verre et les plaquettes PV à base de silicium.

Ce post traitement par de l'eau supercritique avec ou sans oxydant permet d'ajouter une possibilité supplémentaire dans la gradation, modulation du procédé selon l'invention.

En effet, le procédé selon l'invention peut ainsi conduire à une délamination simple partielle ou complète du dispositif multicouche lorsque l'on ne met en œuvre que l'étape de traitement par un fluide pulsé, tel que le CO₂ pulsé, sans post-traitement ; à une déstructuration partielle ou complète lorsque l'on met en œuvre un post-traitement, par la vapeur d'eau saturée ou l'eau subcritique, éventuellement en présence d'un agent oxydant ; et enfin, au stade ultime, lorsque l'on met en œuvre un post-traitement en présence d'eau à l'état supercritique avec ou sans présence d'un agent oxydant, le procédé selon l'invention conduit à la destruction, décomposition partielle, voire à la décomposition, destruction totale de tous les composés organiques du dispositif multicouche.

Dans tous les cas, l'ajout d'un agent oxydant en surstœchiométrie permet de réduire de manière significative les durées de traitement.

Le procédé selon l'invention est totalement modulable car il permet selon que le traitement au fluide pulsé soit couplé ou non à un post-traitement tel que décrit plus haut, et selon le type de ce post traitement de délaminer partiellement ou totalement le dispositif multicouche, tel qu'un le module PV, ou bien de détruire par combustion, en présence ou non d'un oxydant, la partie organique en vue du recyclage uniquement de la partie inorganique.

Le traitement au fluide pulsé et le post-traitement peuvent soit être mis en œuvre séparément dans des réacteurs adaptés au milieu réactionnel, à savoir le CO₂ SC d'une part, et la vapeur saturée, l'eau subcritique, ou l'eau supercritique d'autre part, ou bien dans un réacteur unique. Dans ce cas, le matériau constituant le réacteur unique sera un matériau, tel que l'Inconel, qui résiste au milieu le plus agressif mis en œuvre, à savoir l'eau supercritique.

Le traitement au fluide pulsé et le post-traitement sont complémentaires et leur association est véritablement synergique.

On peut considérer que le traitement au fluide pulsé, tel que le CO₂ pulsé, est un prétraitement qui permet de décoller par gonflement et de manière efficace, les couches organiques, par exemple d'un substrat inorganique afin de préparer la séparation des différentes couches.

Ensuite, une délamination ultime intervient lors du post-traitement, par de la vapeur d'eau saturée, ou de l'eau subcritique en présence ou non d'un oxydant tel que de l'oxygène, de l'air ou du peroxyde d'hydrogène. Ou bien une décomposition des couches organiques se produit lors du post-traitement utilisant de l'eau supercritique en présence ou non d'un oxydant tel que de l'oxygène, de l'air ou du peroxyde d'hydrogène.

Les étapes a) à e) d'une part, et le ou les post-traitement(s) d'autre part, tels que les étapes f) ou g) ou h) d'autre part, sont réalisées dans le même réacteur ou dans des réacteurs séparés.

Avantageusement, le dispositif multicouche peut être un panneau photovoltaïque, un module photovoltaïque, tel qu'un module photovoltaïque mettant en œuvre une technologie au silicium, par exemple au silicium cristallin, ou tout module photovoltaïque, comportant au moins une couche organique ,-un emballage alimentaire, un emballage pharmaceutique, un dispositif électronique tel qu'un écran d'ordinateur, un téléphone portable, un téléviseur, ou un dispositif à diodes électroluminescentes notamment à diodes électroluminescentes organiques.

Finalement, en conclusion, le procédé selon l'invention permet le recyclage de dispositifs multicouche tels que les modules Photovoltaïques (PV) en utilisant un ou plusieurs fluides notamment des fluides supercritique (SC) ou subcritique.

Le procédé selon l'invention, dans les différents modes de réalisation décrits plus haut permet de séparer les différentes couches constitutives d'un dispositif multicouche, tel qu'un module PV en vue de son recyclage.

Le procédé selon l'invention permet ainsi de récupérer le verre et les cellules PV pour leur recyclage mais également les bandes de connexion, par exemple en cuivre étamé. La qualité du verre récupéré est excellente, en effet le procédé selon l'invention n'apporte pas de contamination, et il est ainsi possible de récupérer un verre de bonne qualité.

Le procédé selon l'invention permet également une dégradation graduée des couches polymériques et une récupération sélective des composants valorisables contenus dans un panneau PV quelle que soit sa technologie, et jusqu'aux feuillets polymériques.

Le procédé selon l'invention est respectueux de l'environnement. En effet, le procédé selon l'invention met généralement en œuvre des fluides dits subcritiques et supercritiques et non des solvants organiques toxiques.

De plus, les fluides utilisés dans le procédé selon l'invention peuvent être facilement récupérés purs et recyclés.

D'autres caractéristiques et avantages de l'invention apparaîtront mieux à la lecture de la description détaillée qui suit. Cette description détaillée est faite à titre illustratif et non limitatif, en liaison avec les dessins joints.

### BRÈVE DESCRIPTION DES DESSINS

- La Figure 1 représente, de manière schématique, une vue latérale en coupe d'un module photovoltaïque (module PV), mettant en œuvre une technologie au silicium cristallin.
- La Figure 2 est un graphique qui montre le profil de pression mise en œuvre dans le procédé du document [3].
   En abscisse est porté le temps, et en ordonnée est portée la pression.
- La figure 3 est un graphique qui montre un profil de pression mis en œuvre dans le procédé selon l'invention.
   En abscisse est porté le temps, et en ordonnée est portée la pression.
- La Figure 4 représente, de manière schématique une vue latérale en coupe d'une installation pour la mise en œuvre du procédé selon l'invention, dit procédé au fluide pulsé, par exemple au CO₂ pulsé.
- La Figure 5 représente, de manière schématique, une vue latérale en coupe d'une installation pour la mise en œuvre d'un post-traitement à la vapeur d'eau saturée, à l'eau subcritique, ou à l'eau supercritique selon l'invention.
- La Figure 6 montre des photographies des échantillons de l'exemple 1 avant le traitement (FIG. 6A, 6B et 6C) et à l'issue du traitement (FIG. 6D, 6E, et 6F).

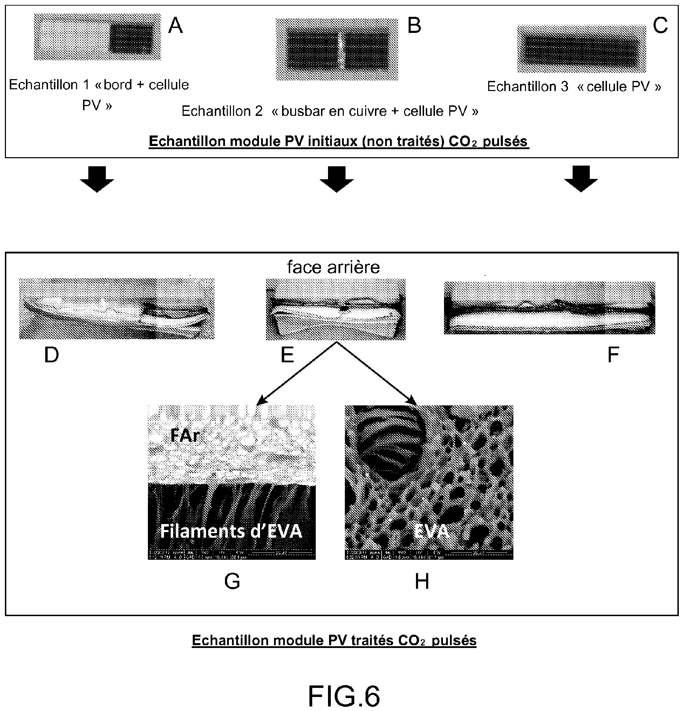

   La Figure 6 montre également des photographies prises au microscope électronique à balayage (MEB) de l'échantillon de la Figure 6E à l'issue du traitement: FIG. 6F et 6G.

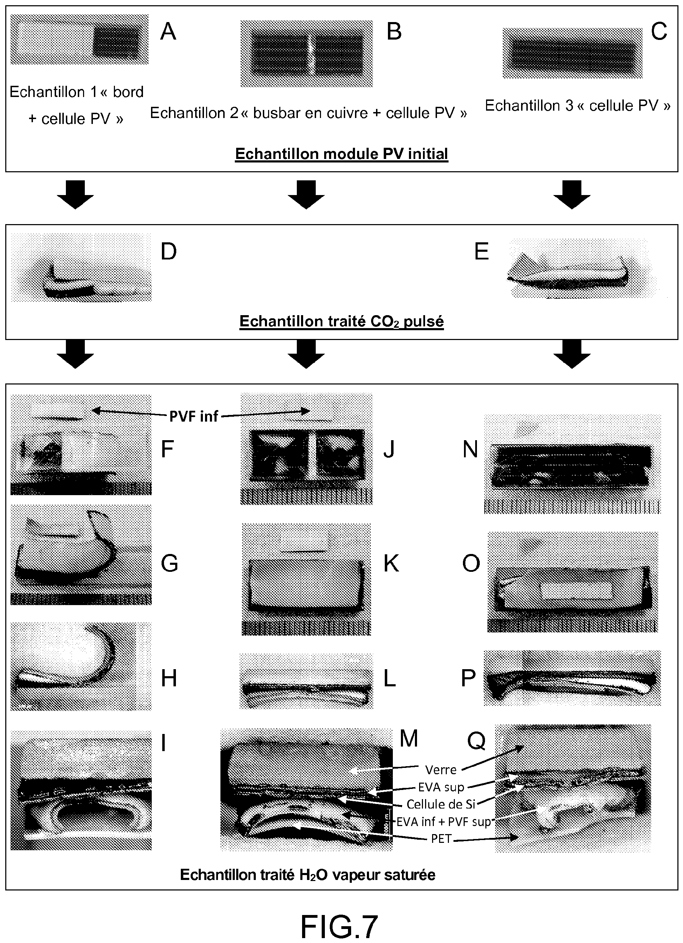

- La Figure 7 montre des photographies des échantillons de l'exemple 2 avant le traitement (FIG. 7A, 7B et 7C), à l'issue du traitement par le CO₂ pulsé (FIG. 7D et 7E), et à l'issue du traitement par la vapeur d'eau saturée (FIG. 7F à 7Q).

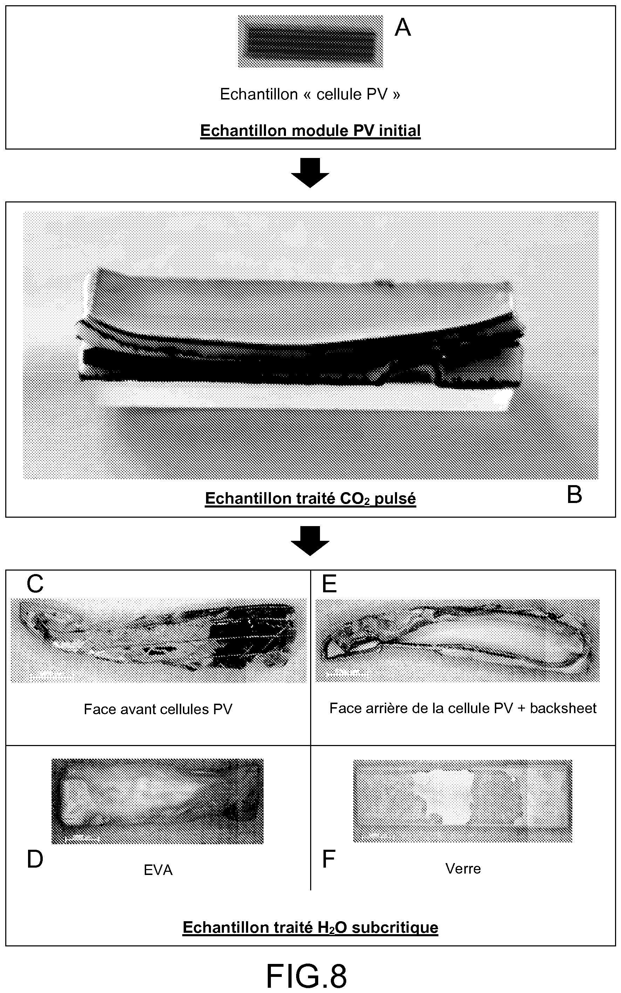

- La Figure 8 montre une photographie de l'échantillon de l'exemple 3 avant le traitement (FIG. 8A), à l'issue du traitement par le CO₂ pulsé (FIG. 8B), et à l'issue du traitement par l'eau subcritique (FIG. 8C, 8D, 8 E, et 8F).

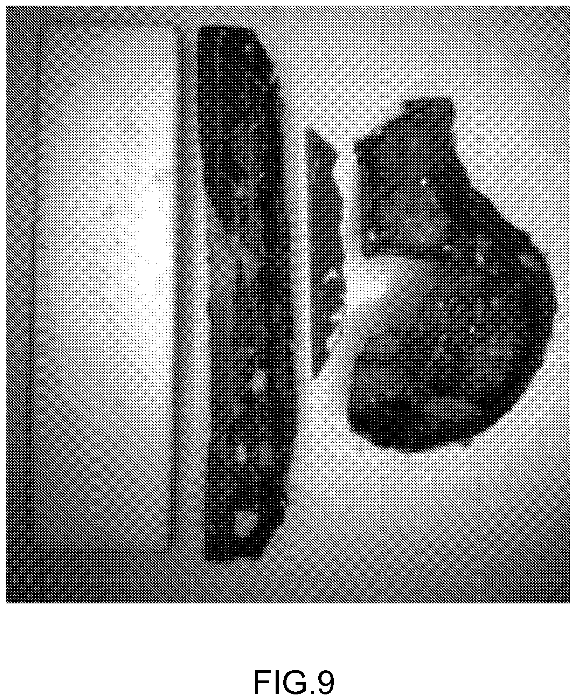

- La Figure 9 montre une photographie de l'échantillon de l'exemple 4 à l'issue du traitement par l'eau supercritique.

### EXPOSÉ DÉTAILLÉ DE MODES DE RÉALISATION PARTICULIERS

Dans la description détaillée qui suit, on décrit tout d'abord, en liaison avec la Figure 3 un profil de pression mis en œuvre dans le procédé selon l'invention.

D'autres profils de pression pourraient être envisagés à la condition toutefois que la succession répétée d'une compression brutale et instantanée du fluide et d'une décompression brutale et instantanée du fluide entre des états physiques différents soit réalisée.

En outre, sur la Figure 3, le fluide à la pression P1, haute, est dans un état supercritique et le fluide à la pression P2, basse, est dans un état gazeux, liquide ou solide, mais on comprendra que le fluide pourrait se trouver dans un état gazeux à la pression P1 et dans un état liquide ou solide à la pression P2, ou que le fluide pourrait se trouver dans un état gazeux à la pression P1 et dans un état liquide ou solide à la pression P2, ou que le fluide pourrait se trouver dans un état liquide à la pression P1 et dans un état solide à la pression P2.

Le fluide, tout d'abord à une pression P0 qui est généralement la pression atmosphérique, et à une température T0 qui est généralement la température ambiante, est amené à une Pression P1 et à une température T1 toutes deux respectivement supérieures à la pression critique Pc et à la température critique Tc (par exemple Pc = 7,4 MPa, et Tc = 31°C) auxquelles le fluide se trouve dans un état supercritique.

Un palier d'une durée t1 est observé à cette pression P1.

Notons que, sur la Figure 3, les durées t1 du premier palier et du dernier palier à la pression P1 représentées, sont plus longues que les durées t1 des autres paliers, mais cela n'est qu'un exemple, et l'une et/ou l'autre des durées t1 du premier palier et du dernier palier pourraient être identiques à la durée t1 des autres paliers à la pression P1 ou plus courtes, selon les besoins.

Ensuite, on effectue une décompression instantanée, brutale, du fluide depuis la pression P1 jusqu'à une pression P2 à laquelle le fluide se trouve par exemple dans un état gazeux, cette décompression peut être poursuivie jusqu'à la pression atmosphérique à laquelle le fluide se trouve par exemple dans un état liquide ou solide en fonction de l'ajustement de la valeur de la pression P2 jusqu'à P0. Un palier d'une durée t2 est observé à cette pression P2.

Sur la figure 3, la durée t2 est identique à la durée t1, mais cela n'est qu'un exemple, et cette durée t2 pourrait être supérieure ou inférieure à t1 et être ajustée, par exemple cette durée t2 pourrait être supérieure ou inférieure à t1 au début, et/ou pendant et/ou à la fin d'un cycle de pulsations, selon les besoins.

Puis on effectue une compression instantanée, brutale, du fluide depuis la pression P2 jusqu'à la pression P1 à laquelle le fluide se trouve par exemple dans un état gazeux à laquelle le fluide se trouve dans un état supercritique. Un palier d'une durée t1 est observé à cette pression P1.

Ensuite on effectue une décompression instantanée, brutale du fluide depuis la pression P1 jusqu'à la pression P2 à laquelle le fluide se trouve par exemple dans un état gazeux (décompression adiabatique jusqu'à une pression inférieure à la pression critique Pc, par exemple 7.3 MPa), cette décompression peut être poursuivie jusqu'à la pression atmosphérique à laquelle le fluide se trouve par exemple dans un état liquide ou solide (décompression non adiabatique jusqu'à la pression atmosphérique lors de laquelle le fluide change d'état : du domaine supercritique vers l'état gazeux, puis l'état liquide, puis l'état solide). Un palier d'une durée t2 est observé à cette pression P2.

La succession de la compression instantanée, brutale, du fluide depuis la pression P2 jusqu'à la pression P1, du palier de durée t1, de la décompression instantanée, brutale du fluide depuis la pression P1 jusqu'à la pression P2 et du palier de durée t2, constitue une pulsation, cycle ou « pulse ».

Sur la Figure 3, cette pulsation est répétée deux fois après la première pulsation que l'on vient de décrire.

Ensuite, à l'issue de la dernière pulsation (n = 5 pulsations au total sur la figure 3), on effectue une compression brutale et instantanée du fluide depuis la pression P2 jusqu'à la pression P1. Un palier d'une durée t1 est observé à cette pression P1.

Comme on l'a déjà mentionné plus haut, notons que, sur la Figure 3, les durées t1 du premier palier et du dernier palier à la pression P1 représentées sont plus longues que les durées des autres paliers, mais cela n'est qu'un exemple, et l'une et/ou l'autre des durées t1 du premier palier et du dernier palier pourraient être identiques à la durée t1 des autres paliers ou plus courtes, selon les besoins.

Enfin, on effectue une décompression aussi brutale et instantanée que possible depuis la pression P1, ici jusqu'à la pression initiale P0.

On décrit maintenant plus particulièrement un mode de réalisation du procédé selon l'invention dans lequel le dispositif multicouche est un module photovoltaïque PV, plus particulièrement un module photovoltaïque mettant en œuvre une technologie au silicium cristallin (FIG. 1), et le fluide est le CO₂.

Cependant, l'homme du métier pourra facilement appliquer les enseignements de la description détaillée qui suit à d'autres dispositifs multicouche et à d'autres fluides.

On commence par décrire un premier mode de réalisation du procédé selon l'invention, dans lequel on réalise seulement un traitement au CO₂ pulsé, sans post-traitement.

La Figure 4, montre de manière schématique, une vue latérale en coupe d'une installation pour la mise en œuvre du procédé selon l'invention selon ce mode de réalisation.

Cette installation, comprend un réservoir de CO₂ sous pression (41), par exemple sous une pression de 50 bars. Le CO₂ est acheminé au moyen d'une pompe haute pression HP (42) par l'intermédiaire d'une canalisation (43), munie de vannes (44, 45) dans un échangeur supercritique ou réchauffeur (46), où il est porté à une température supérieure à la température critique et à une pression supérieure à la pression critique. Le CO₂ supercritique est ensuite amené par une canalisation (47) dans une capacité de CO₂ Haute pression (CO₂ supercritique) (48). Le CO₂ supercritique est ensuite acheminé depuis la capacité (48) vers le réacteur de délamination haute pression (c'est-à-dire le contacteur CO₂/substrat (module PV) à traiter) (49), par une canalisation (410) munie d'une vanne haute pression (411). Dans le réacteur (49) est réalisé le traitement au CO₂ pulsé.

Le CO₂ (gazeux) est ensuite évacué depuis le réacteur (49) par l'intermédiaire d'une canalisation (412) munie d'une vanne haute pression (413).

Les modules PV peuvent être prédécoupés au préalable ou non de manière à augmenter la surface de contact entre les interfaces des couches du module PV et le milieu réactionnel (CO₂).

Les modules sont disposés dans le réacteur haute-pression (49), qui comprend une entrée (414) et une sortie (415) pour le CO₂, de manière à permettre la percolation du CO₂ au travers des couches du ou des modules PV à l'intérieur du réacteur.

L'homme du métier pourra facilement mettre au point la disposition adéquate de l'entrée et de la sortie de CO₂, et du ou des modules PV pour que le CO₂ traverse les couches du ou des modules PV.

On établit ensuite dans le réacteur une pression et une température de consigne.

Les pression et température de consigne fixées initialement dans le réacteur sont supérieures respectivement à la pression Pc et à la température Tc critiques du CO₂, à savoir, respectivement, 7,4 MPa et 31°C.

Idéalement, la pression de consigne est comprise entre 7,4 et 70 MPa et la température de consigne est comprise entre 35°C et 100°C.

La pression de consigne et la température de consigne sont ajustables selon la taille des modules à traiter.

Une fois la pression et la température de consigne atteintes, un palier de 1 seconde à 60 minutes, par exemple 5 minutes, est effectué à cette pression et à cette température.

La durée du palier est également ajustable selon la taille des modules à traiter.

La pression est ensuite abaissée, jusqu'à une pression que l'on peut qualifier de basse, généralement de 7,3 à 0,1 MPa, par exemple jusqu'à 0,1 MPa, pour permettre le passage du CO₂ à un état gazeux, et ainsi provoquer le gonflement des couches imprégnées par le CO₂. Un nouveau palier de 1 seconde à 60 minutes, par exemple 5 minutes à cette basse pression est respecté, avant de pressuriser à nouveau le système à la pression de consigne.

Ce cycle de pulsation basse et haute pression est répété de 2 à 1000 fois, de préférence de 2 à 10 fois.

Le traitement peut être réalisé en mode batch statique (sans alimentation continu de CO₂) ou en mode batch dynamique (alimentation en continu de CO₂). L'utilisation de l'un ou l'autre de ces modes de traitement permet le recyclage du CO₂.

On décrit maintenant un deuxième mode de réalisation du procédé selon l'invention, dans lequel on réalise un traitement au CO₂ pulsé, suivi d'un traitement par la vapeur d'eau saturée (post traitement). En d'autres termes, dans ce deuxième mode de réalisation un traitement au CO₂ pulsé, est couplé à un traitement par la vapeur d'eau saturée (post traitement).

Le traitement au CO₂ pulsé et le traitement par la vapeur d'eau saturée peuvent être mis en œuvre séparément, chaque traitement étant réalisé successivement dans un réacteur distinct, et chaque réacteur étant adapté au milieu réactionnel utilisé lors du traitement, à savoir soit le CO₂ pulsé, soit la vapeur d'eau saturée.

Ou bien, le traitement au CO₂ pulsé et le traitement par la vapeur d'eau saturée peuvent être mis en œuvre successivement dans un réacteur unique.

Dans ce qui suit, on décrit le mode de réalisation ou le traitement au CO₂ pulsé et le traitement par la vapeur d'eau saturée sont mis en œuvre séparément, dans des réacteurs et installations différents.

Les modules PV peuvent être prédécoupés au préalable ou non de manière à augmenter la surface de contact entre les interfaces des couches du module PV et le milieu réactionnel (CO₂ pulsé ou vapeur d'eau saturée).

Le traitement au CO₂ pulsé est réalisé de la manière déjà décrite plus haut.

Ce traitement peut être mis en œuvre dans l'installation représentée sur la Figure 4, qui a déjà été décrite plus haut.

La Figure 5, montre de manière schématique, une vue latérale en coupe d'une installation pour la mise en œuvre séparée du traitement par de la vapeur d'eau saturée dans ce deuxième mode de réalisation du procédé selon l'invention.

Cette installation, comprend un réservoir d'eau (501), à la pression atmosphérique, 1 bar, et à la température ambiante, par exemple 25°C. L'eau est acheminée au moyen d'une pompe haute pression HP (502) par l'intermédiaire d'une canalisation (503), munie d'une vanne haute pression HP (504), et d'un réchauffeur (505). La vapeur d'eau saturée générée par le réchauffeur (505) (évaporation type flash) est ensuite acheminée par une canalisation (506) vers le réacteur haute pression (507) où est réalisé le traitement par la vapeur d'eau saturée. L'échantillon est placé judicieusement dans le réacteur en contact avec cette vapeur d'eau saturée. Le traitement peut être réalisé en mode batch statique (sans alimentation continu de la vapeur d'eau saturée) ou en mode batch dynamique (alimentation en continu de la vapeur d'eau saturée).

Cette installation comprend en outre éventuellement des moyens (non représentés) pour introduire un agent oxydant dans le réacteur.

La vapeur d'eau saturée est ensuite évacuée depuis le réacteur (507) par l'intermédiaire d'une canalisation (508) munie d'une vanne haute pression (509).

Les modules PV, ayant préalablement subi le traitement par le CO₂ pulsé, sont disposés dans le réacteur haute-pression, qui comprend une entrée (510) et une sortie (511) pour la vapeur d'eau saturée, de manière à ce que les modules PV soient toujours en contact avec la phase vapeur en équilibre thermodynamique dans le système.

L'homme du métier pourra facilement mettre au point la disposition adéquate de l'entrée et de la sortie de vapeur d'eau saturée, et du ou des modules PV pour que les modules PV soient toujours en contact avec la phase vapeur en équilibre thermodynamique dans le système.

On établit ensuite dans le réacteur (507) la pression et la température de consigne auxquelles est réalisé le traitement par la vapeur d'eau saturée.

Idéalement, la pression de consigne est comprise entre 0,2 et 20 MPa et la température de consigne est comprise entre 120°C et 300°C. Une fois cette pression de consigne et cette température de consigne atteintes, un palier de 45 à 180 minutes est effectué. Le milieu peu réactif mais très énergétique de la phase vapeur permet dans ces conditions de dégrader préférentiellement les liaisons intermoléculaires à l'interface des couches en provoquant la délamination à cœur. Un traitement trop long, par exemple d'une durée supérieure à 180 minutes peut entraîner une dégradation thermique des couches organiques polymériques, ce qui n'est pas souhaitable.

On décrit maintenant un troisième mode de réalisation du procédé selon l'invention, dans lequel on réalise un traitement au CO₂ pulsé, suivi d'un traitement par l'eau subcritique (post traitement). En d'autres termes, dans ce troisième mode de réalisation un traitement au CO₂ pulsé, est couplé à un traitement par l'eau subcritique (post traitement).

Le traitement au CO₂ pulsé et le traitement par l'eau subcritique peuvent être mis en œuvre séparément, chaque traitement étant réalisé successivement dans un réacteur distinct, et chaque réacteur étant adapté au milieu réactionnel utilisé lors du traitement, à savoir soit le CO₂ pulsé, soit l'eau subcritique.

Ou bien, le traitement au CO₂ pulsé et le traitement par l'eau subcritique peuvent être mis en œuvre successivement dans un réacteur unique.

Dans ce qui suit, on décrit le mode de réalisation ou le traitement au CO₂ pulsé et le traitement par l'eau subcritique sont mis en œuvre séparément, dans des réacteurs et installations différents.

Les modules PV peuvent être prédécoupés au préalable ou non de manière à augmenter la surface de contact entre les interfaces des couches du module PV et le milieu réactionnel (CO₂ pulsé ou l'eau subcritique).

Le traitement au CO₂ pulsé est réalisé de la manière déjà décrite plus haut.

Ce traitement peut être mis en œuvre dans l'installation représentée sur la Figure 4, qui a déjà été décrite plus haut.

Le traitement par l'eau subcritique, dans ce troisième mode de réalisation du procédé selon l'invention peut être mis en œuvre dans une installation analogue à celle de la Figure 5, moyennant quelques adaptations.

Cette installation, comprend un réservoir d'eau (501), à la pression atmosphérique, 1 bar, et à la température ambiante, par exemple 25°C. L'eau est acheminée au moyen d'une pompe haute pression HP (502), par l'intermédiaire d'une canalisation (503), munie d'une vanne haute pression HP (504), dans un réchauffeur (505) où elle est amenée à un état subcritique. L'eau subcritique est ensuite acheminée par une canalisation (506) vers le réacteur haute pression (507) où est réalisé le traitement par l'eau subcritique.

Les modules PV sont placés judicieusement dans le réacteur, en contact avec l'eau subcritique. Le traitement peut être réalisé en mode batch statique (sans alimentation en continu de l'eau subcritique) ou en mode batch dynamique (alimentation en continu de l'eau subcritique).

L'eau subcritique est ensuite évacuée depuis le réacteur (507) par l'intermédiaire d'une canalisation (508) munie d'une vanne haute pression (509).

Les modules PV, ayant préalablement subi le traitement par le CO₂ pulsé, sont disposés dans le réacteur haute-pression (507), qui comprend une entrée (510) et une sortie (511) pour l'eau subcritique, de manière à ce que les modules PV soient toujours en contact avec l'eau subcritique.

L'homme du métier pourra facilement mettre au point la disposition adéquate de l'entrée et de la sortie d'eau subcritique, et du ou des modules PV pour que les modules PV soient toujours en contact avec l'eau subcritique.

On établit ensuite dans le réacteur la pression et la température de consigne auxquelles est réalisé le traitement par l'eau subcritique.

La température de consigne est inférieure à la température critique de l'eau (374°C). Idéalement, la température de consigne se situe entre 150°C et 350°C. La pression de consigne est inférieure à 22,1 MPa. Une fois la température de consigne et la pression de consigne atteintes, un palier de 30 à 60 minutes est observé. Ces courtes durées de traitement permettent une faible dégradation hydrothermale des composés organiques et privilégient une attaque à l'interface des couches organiques polymériques provoquant ainsi la délamination.

On décrit maintenant un quatrième mode de réalisation du procédé selon l'invention, dans lequel on réalise un traitement au CO₂ pulsé, suivi d'un traitement par l'eau supercritique (post traitement) éventuellement en présence d'un agent oxydant. En d'autres termes, dans ce quatrième mode de réalisation un traitement au CO₂ pulsé, est couplé à un traitement par l'eau supercritique éventuellement en présence d'un agent oxydant (post traitement).

Le traitement au CO₂ pulsé et le traitement par l'eau supercritique, éventuellement en présence d'un agent oxydant, peuvent être mis en œuvre séparément, chaque traitement étant réalisé successivement dans un réacteur distinct, et chaque réacteur étant adapté au milieu réactionnel utilisé lors du traitement, à savoir soit le CO₂ pulsé, soit l'eau supercritique, éventuellement en présence d'un agent oxydant.

Ou bien, le traitement au CO₂ pulsé et le traitement par l'eau supercritique, éventuellement en présence d'un agent oxydant peuvent être mis en œuvre successivement dans un réacteur unique.

Dans ce qui suit, on décrit le mode de réalisation où le traitement au CO₂ pulsé et le traitement par l'eau supercritique, éventuellement en présence d'un agent oxydant, sont mis en œuvre séparément, dans des réacteurs et installations différents.

Les modules PV peuvent être prédécoupés au préalable ou non de manière à augmenter la surface de contact entre les interfaces des couches du module PV et le milieu réactionnel (CO₂ pulsé ou l'eau supercritique éventuellement en présence d'un agent oxydant).

Le traitement au CO₂ pulsé est réalisé de la manière déjà décrite plus haut.

Ce traitement peut être mis en œuvre dans l'installation représentée sur la Figure 4, qui a déjà été décrite plus haut.

Le traitement par l'eau supercritique, éventuellement en présence d'un agent oxydant, dans ce quatrième mode de réalisation du procédé selon l'invention peut être mis en œuvre dans une installation analogue à celle de la Figure 5, moyennant quelques adaptations.

Cette installation, comprend un réservoir d'eau (501), à la pression atmosphérique, 1 bar, et à la température ambiante, par exemple 25°C. L'eau est acheminée au moyen d'une pompe haute pression HP (502), par l'intermédiaire d'une canalisation (503), munie d'une vanne haute pression HP (504), dans un réchauffeur (505) où elle est amenée à un état supercritique. L'eau supercritique est ensuite acheminée par une canalisation (506) vers le réacteur haute pression (507) où est réalisé le traitement par l'eau supercritique.

Les modules PV sont placés judicieusement dans le réacteur en contact avec l'eau supercritique. Le traitement peut être réalisé en mode batch statique (sans alimentation continu de l'eau supercritique) ou en mode batch dynamique (alimentation en continu de l'eau supercritique).

L'eau supercritique est ensuite évacuée depuis le réacteur (507) par l'intermédiaire d'une canalisation (508) munie d'une vanne haute pression (509).

Cette installation comprend, en outre, éventuellement des moyens (non représentés) pour introduire un agent oxydant dans le réacteur.

Les modules, ayant préalablement subi le traitement par le CO₂ pulsé, sont disposés dans le réacteur haute-pression, qui comprend une entrée (510) et une sortie (511) pour l'eau supercritique, de manière à ce que les modules PV soient toujours en contact avec l'eau supercritique, éventuellement en présence d'un agent oxydant.

L'homme du métier pourra facilement mettre au point la disposition adéquate de l'entrée et de la sortie d'eau supercritique, et du ou des modules PV pour que les modules PV soient toujours en contact avec une phase aqueuse.

Cette phase aqueuse peut être constituée exclusivement par de l'eau, ou bien par un mélange constitué par de l'eau, par un agent oxydant.

Les agents oxydants sont les agents oxydants qui sont généralement utilisés pour les traitements d'oxydation à haute température, comme par exemple l'oxygène pur (O₂,), les gaz contenant de l'oxygène tels que l'air (O₂/N₂), et le peroxyde d'hydrogène (H₂O₂).

On établit ensuite dans le réacteur la pression et la température de consigne auxquelles est réalisé le traitement par l'eau supercritique, éventuellement en présence d'un agent oxydant.

Idéalement, la pression de consigne est comprise entre 22,1 et 40 MPa, et la température de consigne est supérieure à la température critique de l'eau (374°C), de préférence la température de consigne est comprise entre 400°C et 500°C. La présence d'un oxydant dans le système permet une durée de traitement courte, comprise entre 20 et 120 minutes. Ces conditions opératoires permettent un traitement des modules PV conduisant à la dégradation poussée, voire à la destruction totale des couches polymériques.

A la différence des deuxième et troisième modes de réalisation, ce quatrième mode de réalisation du procédé selon l'invention peut permettre de détruire totalement les couches organiques polymériques pour recycler les composants inorganiques constitutifs des modules de PV.

Ce quatrième mode de réalisation du procédé selon l'invention conduisant à la dégradation poussée, voire à la destruction totale des matériaux organiques du module PV, constitue le stade ultime dans la gamme des traitements constituées par les divers modes de réalisation décrits plus haut qui de manière graduée permettent une délamination partielle, une délamination totale, une dégradation partielle, une dégradation totale, une destruction partielle et enfin une destruction complète voire totale des couches organiques du module PV.

L'invention va maintenant être décrite en référence aux exemples suivants donnés à titre illustratif et non limitatif.

### Exemples :

### Exemple 1.

Dans cet exemple, on réalise la délamination, conformément au procédé selon l'invention de trois échantillons de modules PV.

Dans cet exemple, le procédé comprend uniquement un traitement au CO₂ SC pulsé.

Premier échantillon (Échantillon 1) : cet échantillon comprend le bord et la cellule PV d'un module PV (échantillon montré sur la Figure 6A).

Deuxième échantillon (Échantillon 2) : cet échantillon comprend les « *busbars* » en cuivre et la cellule PV (échantillon montré sur la Figure 6B).

Troisième échantillon (Échantillon 3) : cet échantillon comprend la cellule PV. (Échantillon montré sur la Figure 6C).

Ces trois échantillons sont traités dans les conditions suivantes :
Les échantillons sont insérés dans un réacteur haute-pression avec une entrée et sortie du CO₂ permettant sa percolation à travers les couches du module PV à l'intérieur du réacteur.

Les consignes de pression et température sont supérieures aux conditions supercritiques du CO₂ (Pc > 7,4 MPa et T > 31 °C).

Dans cet exemple, la pression de consigne (haute pression) est comprise entre 8 à 70 MPa et la température de consigne est comprise entre 35°C et 100°C. Plus exactement, la pression de consigne est de 30 MPa, et la température de consigne est de 50°C.

Une fois les conditions opératoires atteintes, un palier de 5 minutes est effectué.

La pression est ensuite réduite au minimum, jusqu'à une basse pression de 5 MPa, pour permettre le passage vers un état gazeux et ainsi provoquer le gonflement des couches imprégnées ainsi qu'une diffusion importante.

Un nouveau palier de 5 minutes, à cette basse pression de 5 MPa, est respecté avant de pressuriser à nouveau le système à la pression de consigne.

Ce cycle de pulsation basse et haute pressions est répété 5 fois.

Les échantillons sont observés visuellement avant le traitement (FIG. 6A, 6B et 6C) et à l'issue du traitement (FIG. 6D, 6E et 6F).

Après traitement, on observe sur les Figures 6D, 6E, et 6F un gonflement significatif des couches polymériques notamment au niveau de la couche d'EVA.

Les échantillons sont également observés au MEB à l'issue du traitement (FIG. 6G et 6H).

La figure 6H montre la microstructure alvéolaire de la couche polymère d'EVA inférieure obtenue après le traitement, et résultant de l'infiltration du fluide dans la couche d'EVA inférieure. A l'interface entre la Face arrière (Far) de la cellule PV et la couche d'EVA inférieure, le phénomène de délamination des deux couches est amorcé.

Les deux couches ne restent solidaires que par une accroche filamentaire de la couche d'EVA inférieure avec la face arrière (Far) de la cellule PV comme cela est montré sur la figure 6G.

### Exemple 2.

Dans cet exemple, on réalise la délamination, conformément au procédé selon l'invention de trois échantillons de modules PV.

Dans cet exemple, le procédé comprend un traitement au CO₂ SC pulsé suivi d'un traitement par la vapeur d'eau saturée.

Premier échantillon (Échantillon 1): cet échantillon comprend le bord et la cellule PV d'un module PV (échantillon montré sur la Figure 7A).

Deuxième échantillon (Échantillon 2): cet échantillon comprend les « *busbars* » en cuivre et la cellule PV (échantillon montré sur la Figure 7B).

Troisième échantillon (Échantillon 3): cet échantillon comprend la cellule PV (échantillon montré sur la Figure 7C).

Ces trois échantillons sont traités dans les conditions suivantes :
- le traitement au CO₂ pulsé est réalisé dans les mêmes conditions que dans l'exemple 1.
- A l'issue du traitement au CO₂ pulsé, le traitement par la vapeur d'eau saturée des échantillons est réalisé dans un autre réacteur.

Le traitement par vapeur saturée s'effectue de manière à ce que les échantillons soient toujours en contact avec la phase vapeur en équilibre thermodynamique dans le système.

Dans cet exemple, la pression est comprise entre 0,8 et 0,9 MPa et la température entre 168°C et 172°C.

Une fois cette pression et cette température atteintes, un palier de 120 minutes est effectué.

Le milieu peu réactif mais très énergétique de la phase vapeur permet dans ces conditions de dégrader préférentiellement les liaisons intermoléculaires à l'interface des couches en provoquant la délamination à cœur.

Les échantillons sont observés avant le traitement (FIG. 7A, 7B et 7C), à l'issue du traitement par le CO₂ pulsé (FIG. 7D : échantillon de la Figure 7A à l'issue du traitement par le CO₂ pulsé, et FIG. 7E : échantillon de la Figure 7C à l'issue du traitement par le CO₂ pulsé), et à l'issue du traitement par la vapeur d'eau saturée (FIG. 7F à 7Q).

Les Figures 7D et 7E, montrent que, à l'issue du traitement par le CO₂ pulsé, on retrouve la structure gonflée de l'EVA.

Sur l'ensemble des FIG. de 7F à 7Q, une délamination partielle des couches constitutives de l'échantillon PV est observée aux différentes interfaces. Une rétractation de la couche PVF inférieure est observée avec une possible séparation et récupération de cette couche de PVF inférieure. Le verre reste intact après le traitement par vapeur saturée. Sur le premier échantillon de la Figure 7A, comprenant le bord du module on observe à l'issue du traitement par la vapeur d'eau saturée (voir Figure 7G) une séparation totale du verre et de la face arrière (feuille de « *backsheet* ») dans la zone ne comprenant pas la cellule PV soit aux interfaces verre/EVA/ « *backsheet* »*.*

### Exemple 3.

Dans cet exemple, on réalise la délamination, conformément au procédé selon l'invention d'un échantillon de module PV.

Dans cet exemple, le procédé comprend un traitement au CO₂ SC pulsé suivi d'un traitement par l'eau subcritique.

L'échantillon comprend la cellule PV.

L'échantillon est traité dans les conditions suivantes :
- Le traitement au CO₂ pulsé est réalisé dans les mêmes conditions que dans l'exemple 1.
- A l'issue du traitement au CO₂ pulsé, le traitement par l'eau subcritique de l'échantillon est réalisé dans un autre réacteur.

La température de consigne du traitement par l'eau subcritique se situe entre la température d'ébullition de l'eau et sa température critique (374 °C), idéalement entre 150°C et 350°C. La pression reste inférieure à 22,1 MPa. Dans cet exemple particulier, une température de consigne de 350°C, et une pression se situant entre 16 et 17 MPa, sont utilisées.

Une fois cette pression et cette température atteintes, un palier de 120 minutes est observé à cette pression et à cette température. Cette courte durée de traitement permet une faible dégradation hydrothermale des composés organiques et privilégie une attaque à l'interface des couches polymériques provoquant ainsi la délamination.

L'échantillon est observé avant le traitement (FIG. 8A), à l'issue du traitement par le CO₂ pulsé (FIG. 8B), et à l'issue du traitement par l'eau subcritique (FIG. 8C, 8D, 8E, et 8F).

Après traitement on obtient la séparation totale de la face avant, constituée d'une plaque de verre, mais également de la couche d'EVA supérieure permettant ainsi de séparer la partie supérieure du module PV, de la cellule PV qui reste collée à la face arrière (feuille de « *backsheet* »)*.* Une dégradation partielles des couches est observée (FIG 8C, 8D et 8E). Le verre présente une dégradation superficielle (FIG 8F).

### Exemple 4.

Dans cet exemple, on réalise la délamination, conformément au procédé selon l'invention d'un échantillon de module PV.

Dans cet exemple, le procédé comprend un traitement au CO₂ SC pulsé suivi d'un traitement par l'eau supercritique.

L'échantillon comprend la cellule PV (seulement la cellule PV).

Cet échantillon est traité dans les conditions suivantes :
- Le traitement au CO₂ pulsé est réalisé dans les mêmes conditions que dans l'exemple 1.
- A l'issue du traitement au CO₂ pulsé, le traitement par l'eau supercritique de l'échantillon est réalisé dans un autre réacteur.

Pour le traitement par l'eau supercritique, l'échantillon est placé en contact avec la phase aqueuse dans un réacteur haute pression. Dans cet exemple, la phase aqueuse est composée seulement d'eau pure sans oxydant.

Idéalement, la pression est comprise entre 22,1 et 40 MPa et la température de consigne est supérieure à la température critique de l'eau (> 374°C), de préférence entre 400°C et 500°C.

Dans cet exemple, une température de consigne de 400°C, et une pression se situant entre 28 et 29 MPa sont utilisées.

La présence d'un oxydant dans le système permettrait une durée de traitement courte, de 120 minutes. Dans cet exemple, aucun oxydant n'est utilisé.

L'échantillon est observé à l'issue du traitement par l'eau supercritique (FIG. 9). L'échantillon de module PV présente après un tel traitement une dégradation poussée des couches organiques et inorganiques constitutives du module PV.

Après traitement, on obtient trois fractions distinctes, à savoir:
- le verre fortement altéré par le traitement.
- la couche d'encapsulant en EVA qui est devenue de couleur brune, probablement du fait d'un état de dégradation avancée du polymère
- la plaquette à base de silicium totalement désolidarisée de la partie supérieure du module.

### REFERENCES

[1] US-A-6,063,995.
[2] US-A1-2016/0214368
[3] WO-A1- 2017/037260.
[4] WO-A1-2017/009062.
[5] NIST, 2012, Thermophysical Properties of Fluid Systems, Access data: 09/2017:http://webbook.nist.gov/chemistry/fluid/

## Revendications

1. Procédé de délamination d'un dispositif multicouche comprenant plusieurs couches, au moins l'une de ces couches étant une couche organique, ledit procédé comprenant au moins les étapes successives suivantes :
a) on met en contact le dispositif multicouche avec un fluide ;
b) on effectue une compression brutale et instantanée du fluide en augmentant de manière brutale et instantanée la pression du fluide jusqu'à une pression P1, à laquelle le fluide se trouve dans un premier état physique;
c) on effectue une décompression brutale et instantanée du fluide en diminuant de manière brutale et instantanée la pression du fluide depuis la pression P1 jusqu'à une pression P2 à laquelle le fluide se trouve dans un deuxième état physique, la pression P2 étant inférieure à la pression P1;
d) on répète la succession de l'étape b) et de l'étape c), la succession des étapes b) et c) constituant une pulsation ou cycle;
e) on récupère le dispositif multicouche délaminé,
la compression brutale et instantanée du fluide et la décompression brutale et instantanée du fluide ayant chacune une durée de 1 seconde à 30 secondes.

2. Procédé selon la revendication 1, dans lequel, lors de l'étape a), on met en contact le dispositif multicouche avec un fluide à une température T0, telle que la température ambiante, et une pression P0, telle que la pression atmosphérique.

3. Procédé selon la revendication 1 ou 2, dans lequel, après l'étape a), et avant l'étape b), on réalise les étapes successives a1) et a2) suivantes :
a1) on amène la température du fluide à une température T1, et la pression du fluide à la pression P1, dans lesquelles le fluide se trouve dans un premier état physique, et on observe un palier à ladite pression P1 pendant une durée t1 ;
a2) on effectue une décompression brutale et instantanée du fluide en diminuant de manière brutale et instantanée la pression du fluide depuis la pression P1 jusqu'à la pression P2, et on observe un palier à ladite pression P2 pendant une durée t2;
à l'issue de l'étape b), on effectue l'étape b1) suivante :
b1) on observe un palier à la pression P1 pendant une durée t1;
à l'issue de l'étape c), on effectue l'étape c1) suivante :
c1) on observe un palier à la pression P2 pendant une durée t2; puis
d1) on répète la succession des étapes b) à c1), cette succession des étapes b) à c1) constituant une pulsation ou cycle; puis
à l'issue de l'étape d1), et avant l'étape e), on effectue les étapes successives d2) et d3) suivantes :
d2) on effectue une compression brutale et instantanée du fluide en augmentant de manière brutale et instantanée la pression du fluide depuis la pression P2, jusqu'à la pression P1, et on observe un palier à ladite pression P1 pendant une durée t1;
d3) on effectue une décompression brutale et instantanée du fluide, en diminuant la pression du fluide depuis la pression P1, de préférence jusqu'à la pression P0, telle que la pression atmosphérique.

4. Procédé selon la revendication 3, dans lequel, lors de l'étape a1), on amène le fluide à la température T1, et la pression du fluide à la température P1, de manière brutale et instantanée.

5. Procédé selon l'une quelconque des revendications 1 à 4, dans lequel la pression P2 est égale à la pression P0, de préférence P0 est la pression atmosphérique.

6. Procédé selon l'une quelconque des revendications 1 à 5, dans lequel la compression brutale et instantanée du fluide et la décompression brutale et instantanée du fluide ont chacune une durée de 1 seconde à 10 secondes, en particulier de 1 seconde à 2 ou 5 secondes.

7. Procédé selon l'une quelconque des revendications précédentes, dans lequel le premier état physique est un état supercritique, et le deuxième état physique est un état gazeux, liquide ou solide; ou bien le premier état physique est un état gazeux et le deuxième état physique est un état liquide ou solide ; ou bien le premier état physique est un état liquide et le deuxième état physique est un état solide.

8. Procédé selon l'une quelconque des revendications précédentes, dans lequel la pression P1 est de 5 à 70 MPa et la pression P2 est de 0,1 à 60 MPa.

9. Procédé selon l'une quelconque des revendications précédentes, dans lequel la succession de l'étape de compression b) et de l'étape de décompression c) est réalisée de 2 à 1000 fois, de préférence de 2 à 500 fois, de préférence encore de 2 à 100 fois, mieux de 2 à 50 fois, notamment de 2 à 10 fois, par exemple de 2 à 3, 4, 5 ou 6 fois.

10. Procédé selon l'une quelconque des revendications précédentes, dans lequel le fluide est choisi parmi le dioxyde de carbone CO₂, l'hexafluorure de soufre ; le protoxyde d'azote ; les alcanes linéaires ou ramifiés, de préférence les alcanes linéaires ou ramifiés de 1 à 10 atomes de carbone, notamment de 1 à 5 atomes de carbone, tels que le méthane, les propanes, les butanes, et les pentanes ; les alcanes cycliques, de préférence les alcanes cycliques de 3 à 10 atomes de carbone ; les alcènes linéaires ou ramifiés, de préférence les alcènes linéaires ou ramifiés de 2 à 10 atomes de carbone, notamment de 2 à 5 atomes de carbone, tels que l'éthylène et le propylène ; les alcools, de préférence les alcools aliphatiques de 1 à 5 atomes de carbone comme le méthanol, l'éthanol, les propanols, et les butanols ; et leurs mélanges ; notamment, le fluide peut être choisi parmi les mélanges de dioxyde de carbone CO₂ et d'au moins un autre fluide choisi parmi les fluides énumérés précédemment.

11. Procédé selon l'une quelconque des revendications précédentes, dans lequel un cosolvant est ajouté au fluide ; de préférence :
- le cosolvant est choisi parmi les gaz dont la pression et la température du point critique sont inférieures ou égales à celles du CO₂, comme le N₂O, le propane ou le butane ; et leurs mélanges ; ou
- le cosolvant est choisi parmi l'eau ; les solutions aqueuses ; les alcools, de préférence les alcools aliphatiques de 1 à 5 atomes de carbone comme le méthanol, l'éthanol, les propanols, et les butanols ; les cétones, de préférence les cétones linéaires ou ramifiées de 3 à 10 atomes de carbone comme l'acétone ou la méthyl-éthyl-cétone, ou les cétones cycliques ; les terpènes ; les hydrofluoroéthers ; les cyclohexanes ; et leurs mélanges ; de préférence encore, les solutions aqueuses sont choisies parmi les solutions de détergents comme les tensioactifs anioniques et/ou cationiques; les solutions d'agents complexants ou d'agents chélatants ; et leurs mélanges.

12. Procédé selon la revendication 11, dans lequel le cosolvant est ajouté au fluide à raison de 0,01 à 30% en masse, de préférence à raison de 0,01 à 10% en masse.

13. Procédé selon l'une quelconque des revendications 3 à 12, dans lequel la durée t1 est de 5 secondes à 30 minutes, notamment de 5 secondes à 5, 10, ou 15 minutes, et la durée t2 est de 5 secondes à 30 minutes, notamment de 5 secondes à 5, 10, ou 15 minutes.

14. Procédé selon l'une quelconque des revendications 3 à 13, dans lequel la durée t1 est inférieure à la durée t2 ou bien la durée t1 est supérieure à la durée t2 ; en particulier, la durée t1 est une durée courte, par exemple de 5 secondes à 5 minutes, et la durée t2 est une durée longue, par exemple de 5 minutes à 30 minutes, ou bien la durée t1 est une durée longue, par exemple de 5 minutes à 30 minutes, et la durée t2 est une durée courte, par exemple de 5 secondes à 5 minutes.

15. Procédé selon l'une quelconque des revendications précédentes, dans lequel, préalablement à l'étape a), on découpe le dispositif multicouche en morceaux de plus petite taille.

16. Procédé selon l'une quelconque des revendications précédentes, dans lequel, à l'issue de l'étape e) on réalise un ou plusieurs post-traitements choisis parmi les traitements chimiques, mécaniques, et les opérations de démontage, y compris les opérations de démontage manuelles.

17. Procédé selon l'une quelconque des revendications précédentes, dans lequel à l'issue de l'étape e), on réalise l'étape f) suivante :
f) on met en contact le dispositif multicouche avec une phase constituée par de la vapeur d'eau saturée, et éventuellement par un agent oxydant tel que l'oxygène pur, l'air ou le peroxyde d'hydrogène ; de préférence à une pression de 0,2 à 20 MPa, et à une température de 120°C à 300°C ; de préférence pendant une durée de 15 à 180 minutes, de préférence encore de 15 à 60 minutes, mieux de 45 à 60 minutes ;
ou à l'issue de l'étape e), on réalise l'étape g) suivante :
g) on met en contact le dispositif multicouche avec une phase constituée par de l'eau subcritique, et éventuellement par un agent oxydant tel que l'oxygène pur, l'air ou le peroxyde d'hydrogène; à une pression inférieure à 22,1 MPa, de préférence encore de 0,2 à 20 MPa, et à une température inférieure à 374°C, de préférence entre la température d'ébullition de l'eau et 374°C, de préférence encore de 150°C à 370°C, mieux de 150°C à 350°C, mieux encore de 150°C à 200°C ; de préférence pendant une durée de 30 à 180 minutes, de préférence encore de 30 à 60 minutes, mieux de 45 à 60 minutes ;
ou à l'issue de l'étape e), on réalise l'étape h) suivante :
h) on met en contact le dispositif multicouche avec une phase constituée par de l'eau supercritique, et éventuellement par un agent oxydant tel que l'oxygène pur, l'air ou le peroxyde d'hydrogène à une pression supérieure à 22,1 MPa, de préférence à une pression de 22,1 MPa à 40 MPa ; et à une température supérieure à 374°C, de préférence de 400 à 500°C ; de préférence pendant une durée de 10 à 180 minutes, de préférence encore de 20 à 120 minutes.

18. Procédé selon la revendication 17, dans lequel les étapes a) à e) d'une part, et le ou les post-traitement(s) d'autre part, tels que les étapes f) ou g) ou h) d'autre part, sont réalisées dans le même réacteur ou dans des réacteurs séparés.

19. Procédé selon l'une quelconque des revendications précédentes, dans lequel le dispositif multicouche est un panneau photovoltaïque, un module photovoltaïque, tel qu'un module photovoltaïque mettant en œuvre une technologie au silicium, par exemple au silicium cristallin, ou tout module photovoltaïque comportant au moins une couche organique, un emballage alimentaire, un emballage pharmaceutique, un dispositif électronique tel qu'un écran d'ordinateur, un téléphone portable, un téléviseur, ou un dispositif à diodes électroluminescentes notamment à diodes électroluminescentes organiques.

## Patentansprüche

1. Verfahren zum Delaminieren einer mehrschichtigen Vorrichtung, die mehrere Schichten umfasst, wobei mindestens eine dieser Schichten eine organische Schicht ist, wobei das Verfahren mindestens die folgenden aufeinanderfolgenden Schritte umfasst:
a) Inkontaktbringen der mehrschichtigen Vorrichtung mit einem Fluid;
b) Vornehmen einer starken und schlagartigen Kompression des Fluids durch starkes und schlagartiges Erhöhen des Drucks des Fluids bis auf einen Druck P1, bei dem sich das Fluid in einem ersten physikalischen Zustand befindet;
c) Vornehmen einer starken und schlagartigen Dekompression des Fluids durch starkes und schlagartiges Verringern des Drucks des Fluids vom Druck P1 bis auf einen Druck P2, bei dem sich das Fluid in einem zweiten physikalischen Zustand befindet, wobei der Druck P2 kleiner ist als der Druck P1;
d) Wiederholen der Abfolge von Schritt b) und Schritt c), wobei die Abfolge der Schritte b) und c) ein Pulsieren oder einen Zyklus darstellt;
e) Entnehmen der delaminierten mehrschichtigen Vorrichtung,
wobei die starke und schlagartige Kompression des Fluids und die starke und schlagartige Dekompression des Fluids jeweils eine Dauer von 1 Sekunde bis 30 Sekunden aufweisen.

2. Verfahren nach Anspruch 1, wobei bei Schritt a) die mehrschichtige Vorrichtung bei einer Temperatur T0, wie etwa der Umgebungstemperatur, und einem Druck P0, wie etwa dem Atmosphärendruck, mit einem Fluid in Kontakt gebracht wird.

3. Verfahren nach Anspruch 1 oder 2, wobei nach Schritt a) und vor Schritt b) die folgenden aufeinanderfolgenden Schritte a1) und a2) ausgeführt werden:
a1) Bringen der Temperatur des Fluids auf eine Temperatur T1 und des Drucks des Fluids auf den Druck P1, bei denen sich das Fluid in einem ersten physikalischen Zustand befindet, und Beobachten eines Plateaus auf dem Druck P1 während einer Dauer t1;
a2) Vornehmen einer starken und schlagartigen Dekompression des Fluids durch starkes und schlagartiges Verringern des Drucks des Fluids vom Druck P1 bis auf den Druck P2, und Beobachten eines Plateaus auf dem Druck P2 während einer Dauer t2;
am Ende von Schritt b), Vornehmen des folgenden Schrittes b1):
b1) Beobachten eines Plateaus auf dem Druck P1 während einer Dauer t1;
am Ende von Schritt c), Vornehmen des folgenden Schrittes c1):
c1) Beobachten eines Plateaus auf dem Druck P2 während einer Dauer t2; und anschließend
d1) Wiederholen der Abfolge der Schritte b) bis c1), wobei diese Abfolge der Schritte b) bis c1) ein Pulsieren oder einen Zyklus darstellt; und anschließend
am Ende von Schritt d1) und vor Schritt e), Vornehmen der folgenden aufeinanderfolgenden Schritte d2) und d3):
d2) Vornehmen einer starken und schlagartigen Kompression des Fluids durch starkes und schlagartiges Erhöhen des Drucks des Fluids vom Druck P2 bis auf den Druck P1, und Beobachten eines Plateaus auf dem Druck P1 während einer Dauer t1;
d3) Vornehmen einer starken und schlagartigen Dekompression des Fluids durch Verringern des Drucks des Fluids vom Druck P1, vorzugsweise bis auf den Druck P0, wie etwa den Atmosphärendruck.

4. Verfahren nach Anspruch 3, wobei bei Schritt a1) stark und schlagartig das Fluid auf die Temperatur T1 und der Druck des Fluids auf die Temperatur P1 gebracht werden.

5. Verfahren nach einem der Ansprüche 1 bis 4, wobei der Druck P2 gleich dem Druck P0 ist, vorzugsweise P0 der Atmosphärendruck ist.

6. Verfahren nach einem der Ansprüche 1 bis 5, wobei die starke und schlagartige Kompression des Fluids und die starke und schlagartige Dekompression des Fluids jeweils eine Dauer von 1 Sekunde bis 10 Sekunden, insbesondere von 1 Sekunde bis 2 oder 5 Sekunden, aufweisen.

7. Verfahren nach einem der vorstehenden Ansprüche, wobei der erste physikalische Zustand ein überkritischer Zustand ist und der zweite physikalische Zustand ein gasförmiger, flüssiger oder fester Zustand ist; oder aber der erste physikalische Zustand ein gasförmiger Zustand ist und der zweite physikalische Zustand ein flüssiger oder fester Zustand ist; oder aber der erste physikalische Zustand ein flüssiger Zustand ist und der zweite physikalische Zustand ein fester Zustand ist.

8. Verfahren nach einem der vorstehenden Ansprüche, wobei der Druck P1 5 bis 70 MPa beträgt und der Druck P2 0,1 bis 60 MPa beträgt.

9. Verfahren nach einem der vorstehenden Ansprüche, wobei die Abfolge des Kompressionsschrittes b) und des Dekompressionsschrittes c) 2 bis 1000 Mal, vorzugsweise 2 bis 500 Mal, noch bevorzugter 2 bis 100 Mal, besser 2 bis 50 Mal, insbesondere 2 bis 10 Mal, zum Beispiel 2 bis 3, 4, 5 oder 6 Mal, ausgeführt wird.

10. Verfahren nach einem der vorstehenden Ansprüche, wobei das Fluid ausgewählt ist aus Kohlendioxid CO₂, Schwefelhexafluorid; Distickstoffmonoxid; linearen oder verzweigten Alkanen, vorzugsweise linearen oder verzweigten Alkanen mit 1 bis 10 Kohlenstoffatomen, insbesondere mit 1 bis 5 Kohlenstoffatomen, wie etwa Methan, Propanen, Butanen und Pentanen; cyclischen Alkanen, vorzugsweise cyclischen Alkanen mit 3 bis 10 Kohlenstoffatomen; linearen oder verzweigten Alkenen, vorzugsweise linearen oder verzweigten Alkenen mit 2 bis 10 Kohlenstoffatomen, insbesondere mit 2 bis 5 Kohlenstoffatomen, wie etwa Ethylen und Propylen; Alkoholen, vorzugsweise aliphatischen Alkoholen mit 1 bis 5 Kohlenstoffatomen, wie Methanol, Ethanol, Propanolen und Butanolen; und deren Gemischen; insbesondere kann das Fluid ausgewählt sein aus Gemischen von Kohlendioxid CO₂ und mindestens einem weiteren Fluid, ausgewählt aus den vorstehend aufgeführten Fluiden.

11. Verfahren nach einem der vorstehenden Ansprüche, wobei dem Fluid ein Co-Lösungsmittel zugesetzt wird; vorzugsweise:
- das Co-Lösungsmittel ausgewählt ist aus Gasen, deren Druck und deren Temperatur des kritischen Punkts kleiner oder gleich denjenigen von CO₂ sind, wie N₂O, Propan oder Butan; und deren Gemische; oder
- das Co-Lösungsmittel ausgewählt ist aus Wasser; wässrigen Lösungen; Alkoholen, vorzugsweise aliphatischen Alkoholen mit 1 bis 5 Kohlenstoffatomen, wie Methanol, Ethanol, Propanolen und Butanolen; Ketonen, vorzugsweise linearen oder verzweigten Ketonen mit 3 bis 10 Kohlenstoffatomen, wie Aceton oder Methyl-Ethyl-Keton, oder cyclischen Ketonen; Terpenen; Hydrofluorethern; Cyclohexanen; und deren Gemische; noch bevorzugter die wässrigen Lösungen ausgewählt sind aus Lösungen von Detergenzien, wie anionischen und/oder kationischen Tensiden; Lösungen von Komplexbildnern oder Chelatbildnern; und deren Gemische.

12. Verfahren nach Anspruch 11, wobei das Co-Lösungsmittel dem Fluid in einer Menge von 0,01 bis 30 Massen-%, vorzugsweise in einer Menge von 0,01 bis 10 Massen-%, zugesetzt wird.

13. Verfahren nach einem der Ansprüche 3 bis 12, wobei die Dauer t1 5 Sekunden bis 30 Minuten, insbesondere 5 Sekunden bis 5, 10 oder 15 Minuten, beträgt und die Dauer t2 5 Sekunden bis 30 Minuten, insbesondere 5 Sekunden bis 5, 10 oder 15 Minuten, beträgt.

14. Verfahren nach einem der Ansprüche 3 bis 13, wobei die Dauer t1 kleiner ist als die Dauer t2, oder aber die Dauer t1 größer ist als die Dauer t2; insbesondere die Dauer t1 eine kurze Dauer, zum Beispiel von 5 Sekunden bis 5 Minuten, ist und die Dauer t2 eine lange Dauer, zum Beispiel von 5 Minuten bis 30 Minuten, ist, oder aber die Dauer t1 eine lange Dauer, zum Beispiel von 5 Minuten bis 30 Minuten, ist und die Dauer t2 eine kurze Dauer, zum Beispiel von 5 Sekunden bis 5 Minuten, ist.

15. Verfahren nach einem der vorstehenden Ansprüche, wobei vor Schritt a) die mehrschichtige Vorrichtung in Stücke kleinerer Größe geschnitten wird.

16. Verfahren nach einem der vorstehenden Ansprüche, wobei am Ende von Schritt e) eine oder mehrere Nachbehandlungen ausgeführt werden, ausgewählt aus chemischen, mechanischen Behandlungen und Demontageoperationen, einschließlich manuellen Demontageoperationen.

17. Verfahren nach einem der vorstehenden Ansprüche, wobei am Ende von Schritt e) der folgende Schritt f) ausgeführt wird:
f) Inkontaktbringen der mehrschichtigen Vorrichtung mit einer Phase, die aus gesättigtem Wasserdampf und gegebenenfalls einem Oxidationsmittel wie etwa reinem Sauerstoff, Luft oder Wasserstoffperoxid besteht; vorzugsweise bei einem Druck von 0,2 bis 20 MPa und bei einer Temperatur von 120°C bis 300°C; vorzugsweise während einer Dauer von 15 bis 180 Minuten, noch bevorzugter von 15 bis 60 Minuten, besser von 45 bis 60 Minuten;
oder am Ende von Schritt e) der folgende Schritt g) ausgeführt wird:
g) Inkontaktbringen der mehrschichtigen Vorrichtung mit einer Phase, die aus unterkritischem Wasser und gegebenenfalls einem Oxidationsmittel wie etwa reinem Sauerstoff, Luft oder Wasserstoffperoxid besteht; bei einem Druck von kleiner als 22,1 MPa, noch bevorzugter von 0,2 bis 20 MPa, und bei einer Temperatur von kleiner als 374°C, vorzugsweise zwischen dem Siedepunkt des Wassers und 374°C, noch bevorzugter von 150°C bis 370°C, besser von 150°C bis 350°C, noch besser von 150°C bis 200°C; vorzugsweise während einer Dauer von 30 bis 180 Minuten, noch bevorzugter von 30 bis 60 Minuten, besser von 45 bis 60 Minuten;
oder am Ende von Schritt e) der folgende Schritt h) ausgeführt wird:
h) Inkontaktbringen der mehrschichtigen Vorrichtung mit einer Phase, die aus überkritischem Wasser und gegebenenfalls einem Oxidationsmittel wie etwa reinem Sauerstoff, Luft oder Wasserstoffperoxid besteht, bei einem Druck von größer als 22,1 MPa, vorzugsweise bei einem Druck von 22,1 MPa bis 40 MPa; und bei einer Temperatur von größer als 374°C, vorzugsweise von 400 bis 500°C; vorzugsweise während einer Dauer von 10 bis 180 Minuten, noch bevorzugter von 20 bis 120 Minuten.

18. Verfahren nach Anspruch 17, wobei die Schritte a) bis e) einerseits und die eine oder die mehreren Nachbehandlung(en) andererseits, wie etwa die Schritte f) oder g) oder h) andererseits, in demselben Reaktor oder in getrennten Reaktoren ausgeführt werden.

19. Verfahren nach einem der vorstehenden Ansprüche, wobei die mehrschichtige Vorrichtung ein Photovoltaikpaneel, ein Photovoltaikmodul, wie etwa ein Photovoltaikmodul, das eine Technologie mit Silizium, zum Beispiel mit kristallinem Silizium, einsetzt, oder jedes Photovoltaikmodul, das mindestens eine organische Schicht umfasst, eine Lebensmittelverpackung, eine pharmazeutische Verpackung, eine elektronische Vorrichtung wie etwa ein Computerbildschirm, ein Mobiltelefon, ein Fernsehgerät, oder eine Vorrichtung mit Leuchtdioden, insbesondere mit organischen Leuchtdioden, ist.

## Claims

1. A method for delaminating a multilayer device comprising several layers, at least one of these layers being an organic layer, said method comprising at least the following successive steps:
a) placing the multilayer device in contact with a fluid;
b) performing a sudden and instantaneous compression of the fluid by suddenly and instantaneously increasing the pressure of the fluid to a pressure P1, at which the fluid is in a first physical state;
c) performing a sudden and instantaneous decompression of the fluid by suddenly and instantaneously reducing the pressure of the fluid from the pressure P1 to a pressure P2 at which the fluid is in a second physical state, the pressure P2 being less than the pressure P1;
d) repeating the sequence of step b) and step c), the sequence of steps b) and c) forming a pulse or cycle;
e) recovering the delaminated multilayer device,
the sudden and instantaneous compression of the fluid and the sudden and instantaneous decompression of the fluid each having a duration of 1 second to 30 seconds.

2. The method according to claim 1, wherein, during step a), the multilayer device is placed in contact with a fluid at a temperature T0, such as ambient temperature, and a pressure P0, such as atmospheric pressure.

3. The method according to claim 1 or 2, wherein, after step a), and before step b), the following successive steps a1) and a2) are carried out:
a1) bringing the temperature of the fluid to a temperature T1, and the pressure of the fluid to the pressure P1, wherein the fluid is in a first physical state, and observing a plateau at said pressure P1 for a duration t1;
a2) performing a sudden and instantaneous decompression of the fluid by suddenly and instantaneously reducing the pressure of the fluid from the pressure P1 to a pressure P2, and observing a plateau at said pressure P2 for a duration t2;
following step b), the following step b1) is performed:
b1) observing a plateau at the pressure P1 for a duration t1;
following step c), the following step c1) is performed:
c1) observing a plateau at the pressure P2 for a duration t2; then
d1) repeating the sequence of steps b) to c1), this sequence of steps b) to c1) forming a pulse or cycle; then
following step d1), and before step e), the following successive steps d2) and d3) are performed:
d2) performing a sudden and instantaneous compression of the fluid by suddenly and instantaneously increasing the pressure of the fluid from the pressure P2 to a pressure P1, and observing a plateau at said pressure P1 for a duration t1;
d3) performing a sudden and instantaneous decompression of the fluid by suddenly and instantaneously reducing the pressure of the fluid from the pressure P1, preferably to the pressure P0, such as atmospheric pressure.

4. The method according to claim 3, wherein, during step a1), the fluid is brought to the temperature T1, and the pressure of the fluid to the temperature P1, suddenly and instantaneously.

5. The method according to any one of claims 1 to 4, wherein the pressure P2 is equal to the pressure P0, preferably P0 is atmospheric pressure.

6. The method according to any one of claims 1 to 5, wherein the sudden and instantaneous compression of the fluid and the sudden and instantaneous decompression of the fluid each have a duration of 1 second to 10 seconds, in particular from 1 second to 2 or 5 seconds.

7. The method according to any one of the preceding claims, wherein the first physical state is a supercritical state, and the second physical state is a gaseous, liquid or solid state; or the first physical state is a gaseous state and the second physical state is a liquid or solid state; or the first physical state is a liquid state and the second physical state is a solid state.

8. The method according to any one of the preceding claims, wherein the pressure P1 is from 5 to 70 MPa and the pressure P2 is from 0.1 to 60 MPa.

9. The method according to any one of the preceding claims, wherein the sequence of the compression step b) and the decompression step c) is carried out from 2 to 1000 times, preferably from 2 to 500 times, more preferably from 2 to 100 times, even more preferably from 2 to 50 times, in particular from 2 to 10 times, for example from 2 to 3, 4, 5 or 6 times.

10. The method according to any one of the preceding claims, wherein the fluid is chosen from carbon dioxide CO₂, sulfur hexafluoride; nitrous oxide; linear or branched alkanes, preferably linear or branched alkanes of 1 to 10 carbon atoms, in particular 1 to 5 carbon atoms, such as methane, propanes, butanes, and pentanes; cyclic alkanes, preferably cyclic alkanes of 3 to 10 carbon atoms; linear or branched alkenes, preferably linear or branched alkenes of 2 to 10 carbon atoms, in particular 2 to 5 carbon atoms, such as ethylene and propylene; alcohols, preferably aliphatic alcohols of 1 to 5 carbon atoms such as methanol, ethanol, propanols, and butanols; and mixtures thereof; in particular, the fluid can be chosen from mixtures of carbon dioxide CO₂ and at least one other fluid chosen from the fluids cited above.

11. The method according to any one of the preceding claims, wherein a cosolvent is added to the fluid; preferably:
- the cosolvent is chosen from gases for which the pressure and the temperature of the critical point are less than or equal to those of CO₂, such as N₂0, propane or butane; and mixtures thereof; or
- the cosolvent is chosen from water; aqueous solutions; alcohols, preferably aliphatic alcohols of 1 to 5 carbon atoms such as methanol, ethanol, propanols, and butanols; ketones, preferably linear or branched ketones of 3 to 10 carbon atoms such as acetone or methyl-ethyl-ketone, or cyclic ketones; terpenes; hydrofluoroethers; cyclohexanes; and mixtures thereof; more preferably, the aqueous solutions are chosen from detergent solutions such as anionic and/or cationic surfactants; solutions of complexing agents or of chelating agents; and mixtures thereof.

12. The method according to claim 11, wherein the cosolvent is added to the fluid at a rate of 0.01 to 30% by mass, preferably at a rate of 0.01 to 10% by mass.

13. The method according to any one of claims 3 to 12, wherein the duration t1 is from 5 seconds to 30 minutes, in particular from 5 seconds to 5, 10, or 15 minutes, and the duration t2 is from 5 seconds to 30 minutes, in particular from 5 seconds to 5, 10, or 15 minutes.

14. The method according to any one of claims 3 to 13, wherein the duration t1 is less than the duration t2 or the duration t1 is greater than the duration t2; in particular, the duration t1 is a short duration, for example from 5 seconds to 5 minutes, and the duration t2 is a long duration, for example from 5 minutes to 30 minutes, or the duration t1 is a long duration, for example from 5 minutes to 30 minutes, and the duration t2 is a short duration, for example from 5 seconds to 5 minutes.

15. The method according to any one of the preceding claims, wherein, before step a), the multilayer device is cut into smaller-sized pieces.

16. The method according to any one of the preceding claims, wherein, following step e), one or more post-treatments chosen from chemical, mechanical treatments, and disassembly operations, including manual disassembly operations, are carried out.

17. The method according to any one of the preceding claims, wherein following step e), the following step f) is carried out:
f) placing the multilayer device in contact with a phase consisting of saturated water vapor, and optionally of an oxidizing agent such as pure oxygen, air or hydrogen peroxide; preferably at a pressure of 0.2 to 20 MPa, and at a temperature of 120°C to 300°C; preferably for a duration of 15 to 180 minutes, more preferably from 15 to 60 minutes, even more preferably from 45 to 60 minutes;
or following step e), the following step g) is carried out:
g) placing the multilayer device in contact with a phase consisting of subcritical water, and optionally of an oxidizing agent such as pure oxygen, air or hydrogen peroxide; at a pressure less than 22.1 MPa, more preferably at a pressure of 0.2 to 20 MPa, and at a temperature less than 374°C, preferably between the boiling point of water and 374°C, more preferably from 150°C to 370°C, even more preferably from 150°C to 350°C, even more preferably from 150°C to 200°C; preferably for a duration of 30 to 180 minutes, more preferably from 30 to 60 minutes, even more preferably from 45 to 60 minutes;
or following step e), the following step h) is carried out:
h) placing the multilayer device in contact with a phase consisting of supercritical water, and optionally of an oxidizing agent such as pure oxygen, air or hydrogen peroxide at a pressure greater than 22.1 MPa, more preferably at a pressure of 22.1 MPa to 40 MPa; and at a temperature greater than 374°C, preferably from 400 to 500°C; preferably for a duration of 10 to 180 minutes, more preferably from 20 to 120 minutes.

18. The method according to claim 17, wherein steps a) to e), on one hand, and the post-treatment(s), on the other, such as steps f) or g) or h), on the other, are carried out in the same reactor or in separate reactors.

19. The method according to any one of the preceding claims, wherein the multilayer device is a photovoltaic panel, a photovoltaic module, such as a photovoltaic module implementing a silicon technology, for example crystalline silicon, or any photovoltaic module including at least one organic layer, a food packaging, a pharmaceutical packaging, an electronic device such as a computer screen, a mobile telephone, a television set, or a device with light-emitting diodes, in particular with organic light-emitting diodes.
